# EUROPEAN PATENT SPECIFICATION

(11) **EP 2 733 188 B1**
(45) Date of publication and mention of the grant of the patent: **25.05.2016**
(21) Application number: 12193255.2
(22) Date of filing: 19.11.2012
(51) Int. Cl.: C09K 11/06, C07F 9/50, C07F 9/53, C07F 9/655, C07F 9/6558, H01L 51/00, H01L 51/50, H01L 51/52, H01L 51/56

(54) **ORGANIC ELECTROLUMINESCENT DEVICE AND A METHOD OF PRODUCING AN ORGANIC ELECTROLUMINESCENT DEVICE**
ORGANISCHE ELEKTROLUMINESZENTE VORRICHTUNG UND VERFAHREN ZUR HERSTELLUNG EINER ORGANISCHEN ELEKTROLUMINESZENTEN VORRICHTUNG
DISPOSITIF ÉLECTROLUMINESCENT ORGANIQUE ET PROCÉDÉ DE PRODUCTION D'UN DISPOSITIF ÉLECTROLUMINESCENT ORGANIQUE

(43) Date of publication of application: 21.05.2014
(73) Proprietor: OSRAM GmbH, 80807 München (DE); Universitat de València, 46010 Valencia (ES); Universität Basel, 4003 Basel (CH)
(72) Inventor: Vollkommer, Frank, Dr., 82131 Gauting (DE); Bauer, Jürgen, 82407 Wielenbach (DE); Sarfert-Gast, Wiebke, Dr., 91074 Herzogenaurch (DE); Meier, Sebastian, 91090 Effeltrich (DE); Hartmann, David, Dr., 91056 Erlangen (DE); Baranoff, Etienne, Dr., B17 ODE Birmingham (GB); Nazeeruddin, Mohammad Khaja, Dr., 1204 Ecublens (CH); Shavaleev, Nail Malikovich, 1003 Lausanne (CH); Constable, Edwin, 4146 Hochwald (CH); Vonlanthen, David, CA93105 Santa Barbara (US); Bolink, Hendrik Jan, Dr., 46010 Valencia (ES); Tordera Salvador, Daniel, 46010 Valencia (ES); Pertegas Ojeda, Antonio, 46010 Valencia (ES); Delgado, Manuel, 46010 Valencia (ES); Orti, Enrique, 46010 Valencia (ES)
(74) Representative: Epping - Hermann - Fischer

(56) References cited:
- JIANGSHAN CHEN ET AL: "Solution-processable small molecules as efficient universal bipolar host for blue, green and red phosphorescent inverted OLEDs", JOURNAL OF MATERIALS CHEMISTRY, vol. 22, no. 11, 1 January 2012 (2012-01-01), page 5164, XP055058754, ISSN: 0959-9428, DOI: 10.1039/c2jm16463a
- BAOHUA ZHANG ET AL: "High-Efficiency Single Emissive Layer White Organic Light-Emitting Diodes Based on Solution-Processed Dendritic Host and New Orange-Emitting Iridium Complex", ADVANCED MATERIALS, vol. 24, no. 14, 13 March 2012 (2012-03-13), pages 1873-1877, XP055058745, ISSN: 0935-9648, DOI: 10.1002/adma.201104758
- SANG EOK JANG ET AL: "High Power Efficiency in Blue Phosphorescent Organic Light-Emitting Diodes Using a Spirobifluorene Phosphine Oxide Compound", MOLECULAR CRYSTALS AND LIQUID CRYSTALS, vol. 551, no. 1, 18 October 2011 (2011-10-18), pages 206-211, XP055058756, ISSN: 1542-1406, DOI: 10.1080/15421406.2011.600650
- SANG EOK JANG ET AL: "High power efficiency in single layer blue phosphorescent organic light-emitting diodes", JOURNAL OF LUMINESCENCE, ELSEVIER BV NORTH-HOLLAND, NL, vol. 131, no. 12, 7 July 2011 (2011-07-07) , pages 2788-2791, XP028257353, ISSN: 0022-2313, DOI: 10.1016/J.JLUMIN.2011.07.014 [retrieved on 2011-07-18]
- JANG S E ET AL: "High quantum efficiency in simple blue phosphorescent organic light-emitting diodes without any electron injection layer", THIN SOLID FILMS, ELSEVIER-SEQUOIA S.A. LAUSANNE, CH, vol. 519, no. 2, 1 November 2010 (2010-11-01), pages 906-910, XP027427686, ISSN: 0040-6090, DOI: 10.1016/J.TSF.2010.08.143 [retrieved on 2010-09-20]

## Description

The invention relates to an organic electroluminescent device and a method of producing an organic electroluminescent device.

Document D1 (Chen J. et al., Journal of Materials Chemistry; 2012; Vol. 22; pp. 5164 - 5170) describes solution-processable small molecules as efficient universal bipolar host for blue, green and red phosphorescent inverted OLEDs.

Document D2 (Zhang B. et al., Advanced Materials; 2012; Vol. 24; pp. 1873 - 1877) describes a high-efficiency single emissive layer of white organic light-emitting diodes based on solution-processed dendritic host and new orange-emitting iridium complex.

Document D3 (Jang S. et al., Molecular Crystals and Liquid Crystals; 2011; Vol. 551; pp. 206 - 211) describes high power efficiency in blue phosphorescent organic light-emitting diodes using a spirobifluorene phosphine oxide compound.

Document D4 (Jang S. et al., Journal of Luminescence; 2011; Vol. 131; pp. 2788 - 2791) describes high power efficiency in single layer blue phosphorescent organic light-emitting diodes.

In the simplest configuration, an organic electroluminescent device, for example an organic light emitting electrochemical cell (OLEEC), comprises at least one light-emitting functional organic layer sandwiched between two contacts, such as electrodes. Under the application of an electrical field electrons are injected from a cathode into the lowest unoccupied molecular orbital (LUMO) of the light-emitting functional organic layer and migrate towards an anode. Correspondingly, holes are injected from the anode into the highest occupied molecular orbital (HOMO) in the functional organic layer and migrate towards the cathode. When holes and electrons meet in the functional organic layer they may form an excited state which emits electromagnetic radiation, such as visible light. If only one functional organic layer is included in the organic electroluminescent device, the functional organic layer has to fulfill at least three tasks: transport of electrons and holes as well as emission of light with high luminescence efficiency. The functional organic layer can include organic semiconductors, for example ionic transition metal complexes, which support all three processes of charge injection, charge transport and emission recombination.

An organic light emitting electrochemical cell (OLEEC), which emits in the blue spectral range of the electromagnetic radiation, demonstrates up to now really poor performances, low efficiency, low luminance and/or very low stability, for example, of less than 5 hours.

Further, many blue emitting organic light emitting electrochemical cells show a shift in the emission wavelength from blue to green upon driving time. The origin of this effect is not known although in some cases it is related to a concentration effect that is even under photoexcitation the emission wavelength shifts with increasing concentration of the blue emitting emitter material in the thin film.

To overcome the disadvantages of the above mentioned blue emitting organic light emitting electrochemical cell several strategies can be used.

First, the emitter material can be chemical modified by introduction of bulky groups into the emitter material. Bulky-groups increase the distance from one emitter material to the next and therefore decrease the possibility of the excitons to "hop" from one emitter material to another, leading to an increased photoluminescent quantum yield (PLQE) and device efficiency. Unfortunately, the increased distance also decreases the possibility for electrons and holes to "hop" from one emitter material to the next, decreasing the mobilities and limiting the current-densities and therefore the luminances that can be obtained.

Secondly, the emitter material can be used as a host-guest approach. In this approach a wide bandgap emitter material is used as the majority component of the film, and small amounts of a smaller bandgap emitter material is used as the light emitter. However, this is an option only for orange and red emitting OLEECs and does not work for blue and green emitting OLEECs.

The objective of the invention is to provide an organic electroluminescent device with a high efficiency and a method of producing the organic electroluminescent device.

This objective is achieved by an organic electroluminescent device in accordance with Claim 1. Particularly advantageous configurations of the organic electroluminescent device and the producing process are the subject of further claims. According to a one embodiment, an organic electroluminescent device comprises a substrate (1), a first electrode (2) arranged on the substrate (1), a functional organic layer (3) arranged on the first electrode (2), wherein the functional organic layer (3) is adapted to emit electromagnetic radiation, a second electrode (4) arranged on the functional organic layer (3), wherein the functional organic layer (3) comprises a matrix material and an emitter material, wherein the emitter material is neutral or ionically charged, wherein the emitter material is selected from the group of ionic transition metal complex, neutral transition metal complex, polymer emitter and combinations thereof, wherein the matrix material comprises at least one ionic charge carrier transporting material, wherein the ionic charge carrier transporting material is selected from the group of electron-transporting material, a hole-transporting material, ambipolar-transporting material and combinations thereof and wherein the at least one ionic charge carrier transporting material is ionically charged, wherein ionically charged means that the total number of electrons of an atom or molecule is not equal to their total number of protons and thus the atom or molecule has a net positive or negative electrical charge.

According to a further embodiment, an organic electroluminescent device comprises a substrate, a first electrode arranged on the substrate, a functional organic layer arranged on the first electrode, wherein the functional organic layer is adapted to emit electromagnetic radiation, a second electrode arranged on the functional organic layer, wherein the functional organic layer comprises a matrix material and an emitter material, wherein the emitter material is selected from the group of ionic transition metal complex, neutral transition metal complex, polymer emitter and combinations thereof, wherein the matrix material comprises a electron-transporting material and/or a hole-transporting material and/or ambipolar-transporting material, and wherein the matrix material is ionically charged.

In an embodiment, the organic electroluminescent device can be embodied as an organic light emitting electrochemical cell (OLEEC). The organic electroluminescent device or the OLEEC has a substrate where the first electrode is arranged on. Since the first electrode can be embodied in a reflective fashion and the second electrode in a transparent fashion, this would result in that the electromagnetic radiation can be emitted in a direction away from the substrate ("top emitter"). As an alternative, the second electrode can be arranged directly on the substrate or the first electrode arranged directly on the substrate is embodied in transparent fashion, such that the electromagnetic radiation can be emitted through the substrate ("bottom emitter"). As an alternative, both the first and the second electrode can be transparent for the emitted electromagnetic radiation ("top and bottom emitter"). Additionally, an encapsulation can be applied above the second electrode.

In this context, the phrase that a layer or an element is arranged or applied "on" or "above" an another layer or an another element or else "between" two further layers or elements can mean here and hereinafter that the layer or the element is arranged directly on the other layer in direct mechanical and/or electrical contact or on the other element, the two further layers, or elements. Furthermore, said phrase above can also designate an indirect contact, in the case of which further layers and/or elements are arranged between the layer or the element and the another layer or the another element or the two further layers or elements.

In this context, the phrase that a layer or an element is arranged or applied "below" an another layer or an another element or else "between" two further layers or elements can mean here and hereinafter that the layer or the element is arranged directly below the other layer in direct mechanical and/or electrical contact or below the other element, the two further layers, or elements. Furthermore, said phrase above can also designate an indirect contact, in the case of which further layers and/or elements are arranged between the layer or the element and the another layer or the another element or the two further layers or elements.

By way of example, the substrate can comprise glass, quartz, plastic films, metal, metal films, silicon wafers or any other suitable substrate material. If the organic electroluminescent device or the OLEEC is embodied as a so-called "bottom emitter", that is to say that the electromagnetic radiation generated in the active region is emitted through the substrate, then the substrate can be transparent to at least part of the electromagnetic radiation.

The first electrode, which can be transparent and/or embodied as an anode and can thus serve as hole injecting material, can for example comprise a transparent conductive oxide or consist of a transparent conductive oxide. Transparent conductive oxides ("TCO" for short) are transparent conductive materials, generally metal oxides, such as, for example, zinc oxide, tin oxide, cadmium oxide, titanium oxide, indium oxide or indium tin oxide (ITO). Alongside binary metal-oxygen compounds such as ZnO, SnO₂ or In₂O₃, for example, the group of the TCOs also includes ternary metal-oxygen compounds such as, for example, Zn₂SnO₄, CdSnO₃, ZnSnO₃, MgIn₂O₄, GaInO₃, Zn₂In₂O₅ or In₄Sn₃O₁₂ or mixtures of different transparent conductive oxides. Furthermore, it can be possible that the TCOs do not necessarily correspond to a stoichiometric composition and can also be p- or n-doped.

The second electrode can be embodied as a cathode and thus serve as electron injecting material. Inter alia in particular aluminum, barium, indium, silver, gold, magnesium, calcium or lithium and compounds, combinations and alloys thereof can be used as material of the second electrode.

Preferably, the material of the second electrode is selected from the group including aluminum, silver, gold, combinations and alloys thereof. This material of the second electrode is air-stable and/or no reactive. Therefore, a hermetic sealing of the organic electroluminescent device is less demanding compared to typical OLED. This saves costs and time in the production of the organic electroluminescent device of this invention.

As an alternative, or, in addition, the first electrode can also comprise a metal, for example as mentioned in connection with the second electrode. By way of example, the first electrode can comprise a metal layer that is at least partly transparent to the electromagnetic radiation. Furthermore, the first electrode can also comprise an organic electrically conductive material.

One, or optionally a plurality of light emitting functional organic layer(s) can be stacked and/or be neighboured by additional functional layers. The additional functional layers can be selected from a group of electron-transporting and/or electron-injecting and/or from a group of hole-transporting and/or hole-injection materials. By these additional functional layers the balance of charge carriers within the light emitting functional organic layer(s) can be improved and the operation voltage can be decreased. Both measures are leading to improved device efficiency.

According to one embodiment, the organic electroluminescent device comprises one further functional organic layer or a plurality of further functional organic layers, wherein the functional organic layer and at least one further functional organic layer are stacked. The functional organic layer and at least one further functional organic layer can be neighboured directly or indirectly. "Directly neighboured" means here and in the following that the functional organic layer and at least one further functional organic layer are in direct contact to each other und thus no further layers or elements are arranged between the functional organic layer and at least one further functional organic layer. "Indirectly neighboured" means that between the functional organic layer and at least one further functional organic layer are arranged further layers and/or elements, for example additional functional layers.

According to one embodiment, the functional organic layer and/or at least one further functional organic layer are neighboured in a stack by at least one additional functional layer, wherein the additional functional layers are selected from the group of electron-transporting materials, electron-injecting materials, hole-transporting materials, hole-injecting materials and combinations thereof. The functional organic layer and at least one additional functional layer and/or the at least one further functional organic layer and the at least one additional functional layer can be neighboured directly or indirectly.

The functional organic layer and at least one additional functional layer and/or the at least one further functional organic layer and the at least one additional functional layer can be stacked to form a multi-layer structure.

The organic electroluminescent device comprises at least one functional organic layer. Preferably, the organic electroluminescent device includes only one functional organic layer. The one functional organic layer supports the processes of charge injection, charge transport and emission recombination. Multi-layer structures of functional organic layers like electron and/or hole transporting, electron and/or hole blocking and/or emitting layers are not needed for charge injection, charge transport and light emission. This saves material, costs and time for the production of the organic electroluminescent device of this invention.

In an embodiment, the functional organic layer is adapted to emit electromagnetic radiation in the wavelength range of 380 to 800 nm. Preferably, the functional organic layer is adapted to emit electromagnetic radiation in the blue and/or green spectral range. Particularly, the functional organic layer is adapted to emit electromagnetic radiation in the wavelength range of 420 to 490 nm and/or of 490 to 575 nm.

"Electromagnetic radiation" designates here and in the following electromagnetic radiation having one or more wavelengths or wavelength ranges from an ultraviolet to infrared spectral range, referred to as light. Light comprises particularly visible light and wavelengths or wavelength ranges from a visible spectral range between about 350 nm and about 800 nm.

The functional organic layer can comprise organic polymers, organic oligomers, organic monomers, organic small, non-polymeric molecules ("small molecules") or combinations thereof. Depending on the materials in the functional organic layer, the electromagnetic radiation generated can have individual wavelengths or wavelength ranges or combinations thereof from the ultraviolet to infrared spectral range.

According to one embodiment, the emitter material is ionically charged.

The emitter material comprises at least one transition metal complex, which is ionically charged or neutral. As an alternative, or, in addition, the ionic transition metal complex is balanced with a small counter-ion, such as perchlorate (ClO⁴⁻), tetrafluorborate (BF₄⁻), CF₃SO₃⁻, (CF₃SO₂)N⁻, diethylphosphate (EtO)₂PO₄⁻ and /or hexafluorophosphate (PF⁶⁻). In principle, another counter-ion is possible which accompanies the ionic transition metal complex in order to maintain electric neutrality.

According to another embodiment, the functional organic layer comprises more than one ionically charged or neutral transition metal complex, which differs from one another. According to one embodiment, an organic semiconductor comprises at least the charged or neutral transition metal complex or the ionic transition metal complex and its counter-ion.

In this context "ionic" or "ionically charged" means that the total number of electrons of an atom or molecule is not equal to their total number of protons and thus the atom or molecule has a net positive or negative electrical charge.

According to one embodiment, the emitter material comprises a transition metal, wherein the transition metal is selected from the group including a transition metal of the platinum group of the periodic table and a transition metal of the copper group of the periodic table.

Preferably, the ionic transition metal complex is an ionic ruthenium complex, an ionic osmium complex, an ionic copper complex and/or an ionic iridium complex. The ionic transition metal complex can be selected from the group of 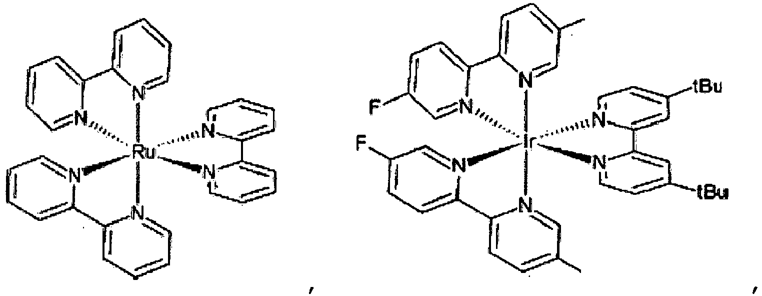 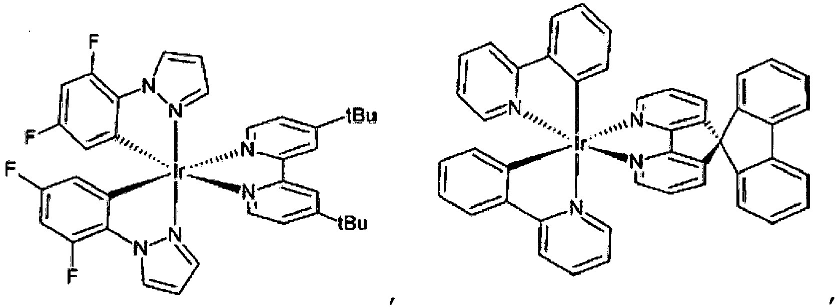 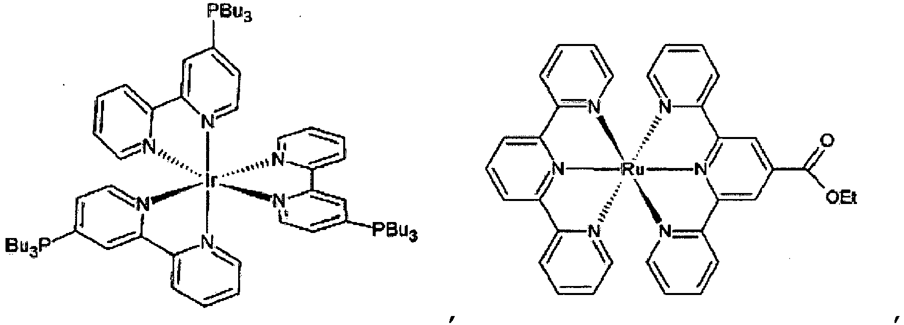 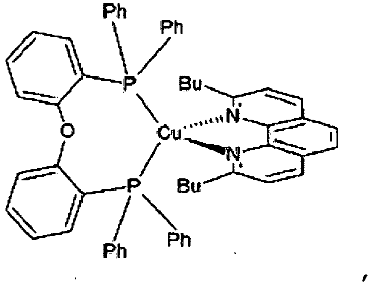 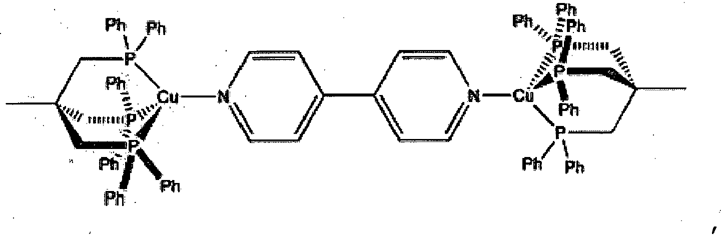 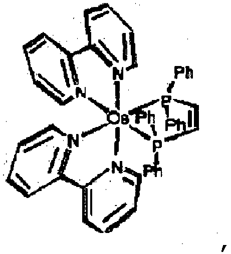 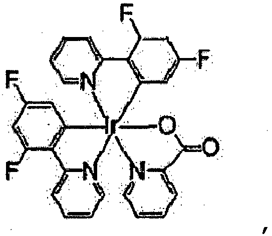 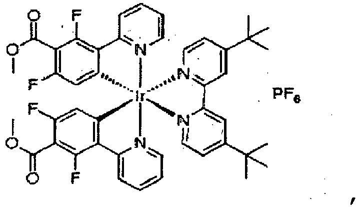 and 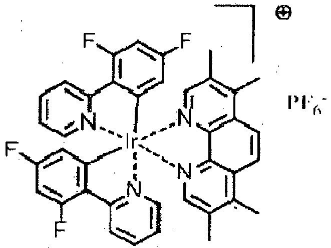 including derivates and combination thereof. tBu means tert-butyl. Et means ethyl. Bu means butyl. Ph means phenyl. The counter-ion can be for example PF₆⁻, ClO₄⁻, ASF₆⁻ or BF₄⁻.

In particular, the ionic transition metal complex is bis-2-phenylpyridine 6-phenyl-2,2'-bipyridine iridium(III) and derivatives thereof.

The counter-ion of the ionic transition metal complex is particularly hexafluorophosphate.

In particular, the organic semiconductor is bis-2-phenylpyridine 6-phenyl-2,2'-bipyridine iridium(III) hexafluorophosphate and derivatives thereof as shown in the following formula:

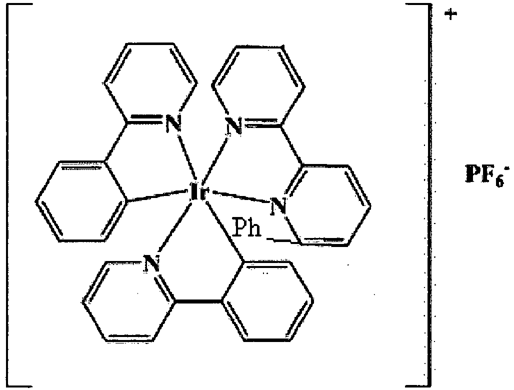

The ionic transition metal complex, particularly the ionic copper complex, ionic osmium complex and/or ionic iridium complex improve(s) the turn-on time, efficiency, brightness, stability and activate all the colours of OLEECs even using other different ionic transition metal complex in the functional organic layer.

The ionic transition metal complex shows an excellent stability in multiple redox states. The electronic charges of the first and second electrode can be readily injected and transported.

The ionic transition metal complex and/or the counter-ion are ionically conducting and/or mobile. When an electric field is applied the mobile ions redistribute under the electric field. As a result ionic double layers are formed at the electrode interfaces leading to high electric fields making both contacts ohmic, thus facilitating the charge injection into the functional organic layer. The injection of holes and electrons causes oxidation and reduction of the organic semiconductor which results in formation of p- and n-doped fronts that propagate to form a dynamic p-n junction. In this state the electric field is concentrated in the vicinity of the p-n junction and the charges migrate due to drift. When injected holes and electrons meet at the organic semiconductor including the ionic transition metal complex site they recombine to form excitons which may result in light emission. The luminescence efficiency of the organic semiconductor can be extremely high, with photoluminescence quantum yield approaching 100 %, as emission from this organic semiconductor arises especially in the case of small molecules almost exclusively from triplet states.

According to one embodiment, the matrix material comprises an additional material, wherein the additional material is neutral or ionically charged, wherein the additional material cormprises at least one polymer and/or salt and/or ionic liquid. The additional material does not transport charge of hopping process, for example holes and/or electrons. The polymer and/or salt and/or ionic liquid can be dispersed in the organic semiconductor or emitter material. The ionic liquid can be selected from a group of 1-Benzyl-3-methylimidazolium hexafluorophosphate, 1-Butyl-2,3-dimethylimidazolium hexafluorophosphate, 1-Butyl-3-methylimidazolium hexafluorophosphate, 1-Ethyl-3-methylimidazolium hexafluorophosphate, 1-Hexyl-3-methylimidazolium hexafluorophosphate, 1-Butyl-1-(3,3,4,4,5,5,6,6,7,7,8,8,8-tridecafluorooctyl)imidazolium hexafluorophosphate, 1-Methyl-3-(3,3,4,4,5,5,6,6,7,7,8,8,8-tridecafluorooctyl)imidazolium hexafluorophosphate, 1-Methyl-3-octylimidazolium hexafluorophosphate, 1-Butyl-2,3-dimethylimidazolium tetrafluoroborate, 1-Butyl-3-methylimidazolium tetrafluoroborate, 1-Ethyl-3-methylimidazolium tetrafluoroborate, 1-Hexyl-3-methylimidazolium tetrafluoroborate, 1-Methyl-3-octylimidazolium tetrafluoroborate, 1-Butyl-3-methylimidazolium trifluoromethanesulfonate, 1-Ethyl-3-methylimidazolium trifluoromethanesulfonate, 1,2,3-Trimethylimidazolium trifluoromethanesulfonate, 1-Ethyl-3-methyl-imidazolium bis(pentafluoroethylsulfonyl)imide, 1-Butyl-3-methylimidazolium bis(trifluoromethylsulfonyl)imide, 1-Butyl-3-methylimidazolium methanesulfonate, Tetrabutylammonium bis-trifluoromethanesulfonimidate, Tetrabutylammonium methanesulfonate, Tetrabutylammonium nonafluorobutanesulfonate, Tetrabutylammonium heptadecafluorooctanesulfonate, Tetrahexylammonium tetrafluoroborate, Tetrabutylammonium trifluoromethanesulfonate, Tetrabutylammonium benzoate,
Tetrabutylammonium chloride,
Tetrabutylammonium bromide, 1-Benzyl-3-methylimidazolium tetrafluoroborate, Trihexyltetradecylphosphonium hexafluorophosphate, Tetrabutylphosphonium methanesulfonate, Tetrabutylphosphonium tetrafluoroborate, Tetrabutylphosphonium bromide, 1-Butyl-3-methylpyridinium bis(trifluormethylsulfonyl)imide, 1-Butyl-4-methylpyridinium hexafluorophosphate, 1-Butyl-4-methylpyridinium tetrafluoroborate, Sodium tetraphenylborate,
Tetrabutylammonium tetraphenylborate, Sodium tetrakis(1-imidazolyl)borate and Cesium tetraphenylborate, and combinations thereof. In particular, the ionic liquid is 1-butyl-3-methylimidazolium hexafluorophosphate or 1-butyl-3-methylimidazolium tetrafluoroborate.

The polymer can be an elastomer, thermoplastic or thermosetting material. Preferably, the polymer is Poly(methyl methacrylate).

According to one embodiment, the organic functional layer including the ionic transition metal complex can be applied by wet-chemical deposition techniques like coating (e.g. spin-coating, doctor blading, slot die coating) or printing (e.g. screen-printing, flexography printing, gravure printing, inkjet printing).

According to one embodiment, the organic functional layer has a layer thickness of 20 nm to 1000 nm, preferably 30 nm to 500 nm, particularly 50 nm to 150 nm, for example 100 nm. According to one embodiment, the ionic charge carrier transporting material has a molecular weight of less than 1000 g/mol. Preferably, the molecular weight is between 500 und 800 g/mol, for example 800 g/mol. Therefore, the matrix material has a low molecular weight.

According to another embodiment, the ionic charge carrier transporting material has a molecular weight of more than 1000 g/mol.

According to one embodiment, the amount of the matrix material in the functional organic layer is more than 60 %, preferably more than 80 %, particularly preferably more than 90 % in terms of weight.
Preferably, the amount of the matrix material in the functional organic layer is between 80 and 99 %, for example 90 % in terms of weight.

In an embodiment, the amount of the emitter material in the functional organic layer is less than 40 % in terms of weight. Preferably, the amount of the emitter material in the functional organic layer is less than 20 % in terms of weight, for example between 1 and 15 %. In a preferred embodiment the amount of the emitter material in the functional organic layer is less than 10 % in terms of weight, for example 5 % in terms of weight.

The amount of the matrix material and/or emitter material in the functional organic layer is not limited to these above mentioned fixed values or ranges. Rather, the amount of the matrix material and/or emitter material can be varied, for example the above mentioned amounts can have a standard deviation of 10 %.

As this concentration is low, the contribution of the ionic transition metal complex to the total ion concentration in the functional organic layer is low and therefore, in principle, also neutral transition metal complex can be employed. Preferably the neutral transition metal complex is soluble in polar solvents used to dissolve the ionic transition metal complex, and lead to good mixing with the ionic transition metal complex.

In an embodiment, the matrix material is a host.

In an embodiment, the at least one ionic charge carrier material is an ambipolar-transporting material. "Ambipolar" means in this context a chemical compound, which can transport or conduct holes as well electrons. Ambipolar-transporting material is a wide bandgap host. In the case of different hole and/or electron mobility additional unipolar transport material can be added to shift the centre and/or location of the emission zone to the centre and/or location of the functional organic layer.

In an embodiment, the ambipolar-transporting material is selected from a group of carbazole-based host materials, tetraphenylsilane based host materials, phosphine oxide-based host materials and triphenylamine-based host materials.

Particularly, the ambipolar-transporting material is selected from the group comprising materials with one of the following structural formulae and derivatives and combinations thereof: 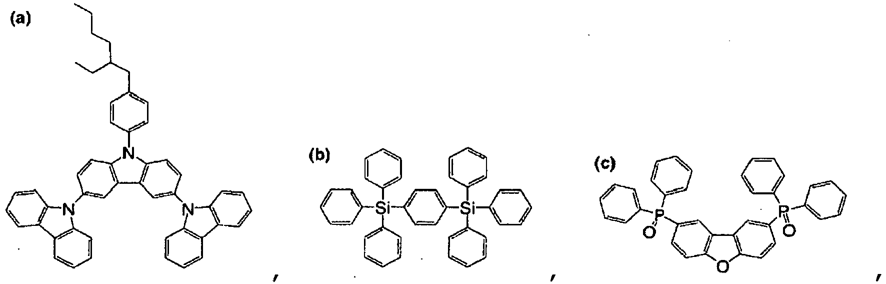 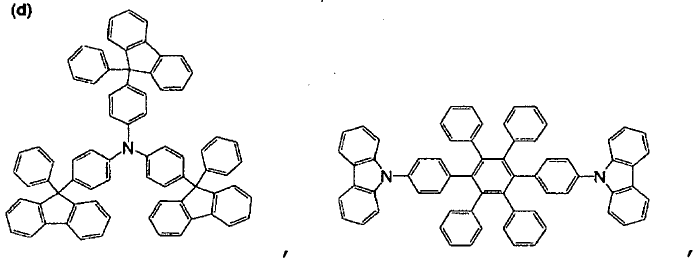 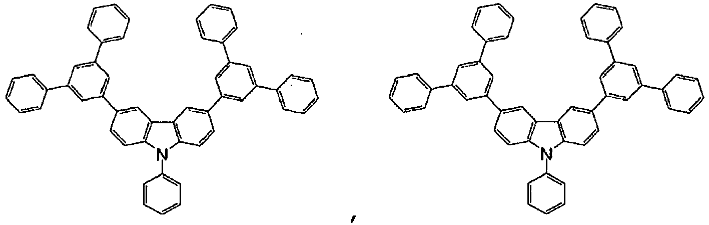 and derivatives and combinations thereof.

Derivative means here and in the following a compound comprising the similar structural unit, wherein single atoms of the structural unit can be replaced by another atom or group of atoms.

According to one embodiment, the matrix material and/or the at least one ionic carrier transporting material is ionically charged. This is a matrix material and/or an at least one ionic carrier transporting material to which an ionic group has been covalently bounded. Ionic groups are selected from a group of imidazolium, tetra-alkyl ammonium, pyridinium, tosylate, carboxylate, sulfonate and combinations thereof. Ionic groups can be either positively or negatively charged. The ionic groups contain a counterion.

In principle, all matrix materials with an ionic group are suitable, which are able to transport holes and/or electrons. According to one embodiment, the matrix material and/or the at least one ionic carrier transporting material transports holes and/or electrons.

According to one embodiment, the electron-transporting material is a conjugated molecule with a low reduction potential.

According to one embodiment, the electron-transporting material comprises at least one structural unit of silole, oxadiazole, triazole, phenanthroline, metal complex, pyridine, triazine, pyrimidine and/or combinations thereof.

According to one embodiment, the electron-transporting material is selected from the group comprising materials with one of the following structural formulae and derivatives and combinations thereof: 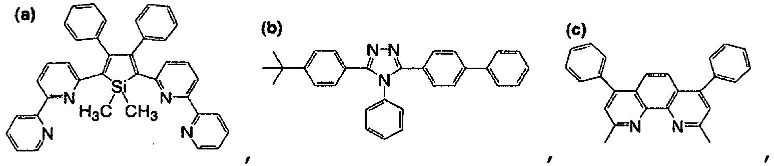 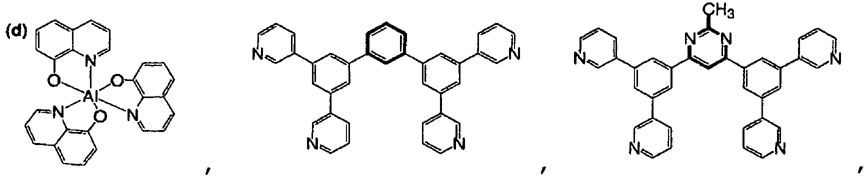 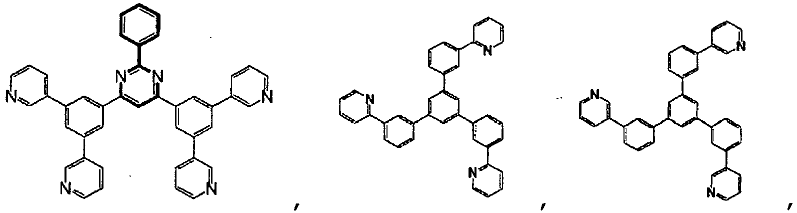 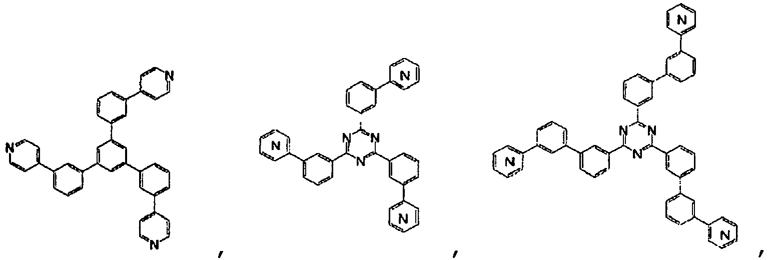 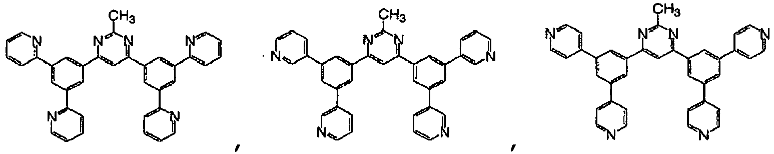 and derivatives and combinations thereof.

According to a further embodiment, the electron-transporting material is selected from the group comprising materials with one of the following structural formulae and derivatives and combinations thereof: 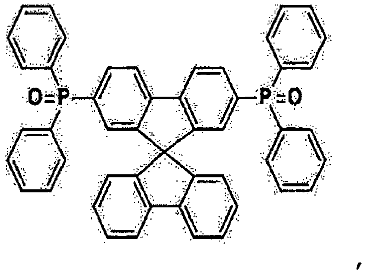 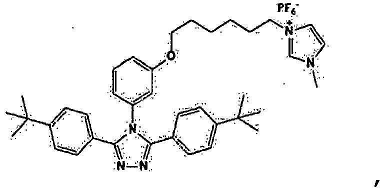 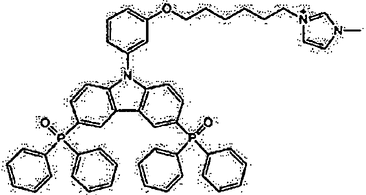 and

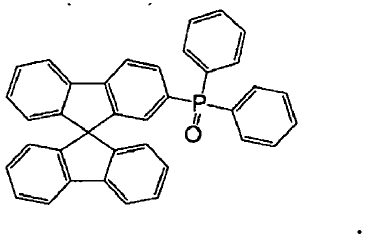

According to one embodiment, the hole-transporting material is a conjugated molecule with a low oxidation potential. This is achieved by the incorporation of electron donating groups such as amines, methoxy- and/or alkyl groups.

According to one embodiment, the hole-transporting material is selected from the group of materials comprising one of the following structural formulae and derivatives and combinations thereof: 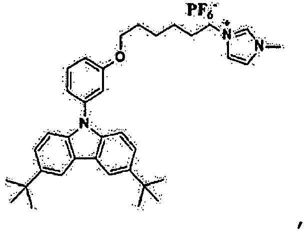 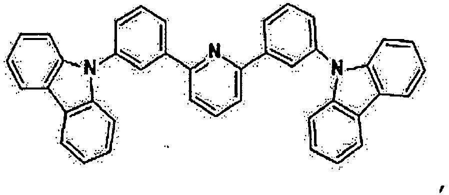 and

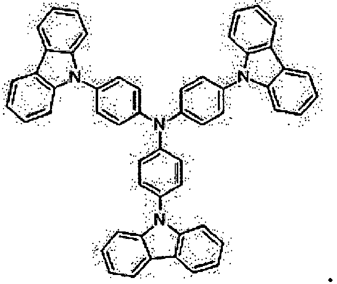

According to one embodiment, the electron-transporting material is ionically charged and the hole-transporting material is ionically charged, or the electron-transporting material is neutral and the hole-transporting material is ionically charged, or the electron-transporting material is ionically charged and the hole-transporting material is neutral.

According to one embodiment, the electron-transporting material is ionic, the hole-transporting material is ionic and the emitter material is ionic. Additional, a salt or an ionic liquid can be comprised in the functional organic layer. Preferably, the functional organic layer comprises no salt and/or ionic liquid.

"Neutral" or "neutrally charged" means in this context, that the material, for example electron-transporting material, hole-transporting material and/or emitter material, has no charge and thus is not ionic. "Ionic" means in this context that the material contains an ionic group in the molecule.

According to one embodiment, the electron-transporting material is ionic, the hole-transporting material is ionic and the emitter material is neutral. Additional, a salt or an ionic liquid can be comprised in the functional organic layer. Preferably, the functional organic layer comprises no salt and/or ionic liquid.

According to one embodiment, the electron-transporting material is neutral, the hole-transporting material is ionic and the emitter material is ionic. Additional, a salt or an ionic liquid can be comprised in the functional organic layer. Preferably, the functional organic layer comprises salt and/or ionic liquid.

According to one embodiment, the electron-transporting material is neutral, the hole-transporting material is ionic and the emitter material is neutral. Additional, a salt or an ionic liquid can be comprised in the functional organic layer. Preferably, the functional organic layer comprises no salt and/or ionic liquid.

According to one embodiment, the electron-transporting material is ionic, the hole-transporting material is neutral and the emitter material is ionic. Additional, a salt or an ionic liquid can be comprised in the functional organic layer. Preferably, the functional organic layer comprises no salt and/or ionic liquid.

According to one embodiment, the electron-transporting material is ionic, the hole-transporting material is neutral and the emitter material is neutral. Additional, a salt or an ionic liquid can be comprised in the functional organic layer. Preferably, the functional organic layer comprises no salt and/or ionic liquid.

It is also possible that the electron-transporting material is neutral, the hole-transporting material is neutral and the emitter material is ionic. Additional, a salt or an ionic liquid can be comprised in the functional organic layer. Preferably, the functional organic layer comprises salt and/or ionic liquid.

According to one embodiment, the functional organic layer comprises or consists of an emitter material with the formula 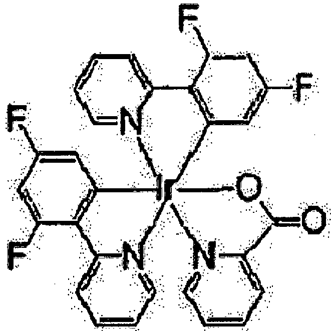 or derivatives thereof and of a hole-transporting material with the formula 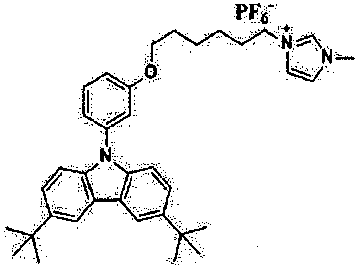 or derivatives thereof and of an electron-transporting material with the formula 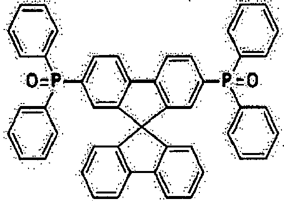 or derivatives thereof.

Preferably, the ratio of electron-transporting material to hole-transporting material to emitter material is equal to 7 to 7 to 2 with a standard deviation of +/- 10 % in terms of weight, for example 6.7 : 6.7 : 1.5 in terms of weight.

By combining an ionically charged matrix material with a neutral or ionically charged emitter material the efficiency of the organic electroluminescent device can be increased. This allows the use of air-stable metals as an electrode and blue emitting emitter material and yields in a stable blue emission of the organic electroluminescent device.

It is important that the matrix material is ionic, as this allows for the preparation of an OLEEC (using air-stable electrodes).

According to one embodiment, the structure of the organic light emitting electrochemical cell (OLEEC) can be simpler as only one functional organic layer is needed. This functional organic layer can be easily applied by wet-chemical deposition technique. In contrast to organic light emitting diodes (OLEDs), the OLEEC does not need reactive electrodes (e.g. Ba, Ca, LiF, CsF, Mg), for example as low work function cathodes for the electron injection. This means that air-stable metals like Au, Al and Ag can be used in OLEECs. Therefore the requirements in terms of encapsulation are less demanding compared to typical OLED devices. In combination with the simple device structure and solution processability, OLEECs are low-cost organic electroluminescent devices.

According to one embodiment, organic electroluminescent device comprises an electron blocking layer, which is arranged above the first electrode. Particulary, the electron blocking layer comprises or consists of poly(N-vinylcarbazole) (PVK).

According to one embodiment, the organic electroluminescent device comprises a hole blocking layer, which is arranged below the second electrode.

In an embodiment, the organic electroluminescent device according to the present disclosure can be produced by the following method:
A) Provision of a substrate,
B) Provision of a first electrode and a second electrode,
C) Provision of a functional organic layer,
   - wherein the functional organic layer is adapted to emit electromagnetic radiation,
   - wherein the functional organic layer comprises a matrix material and an emitter material,
   - wherein the emitter material is neutral or ionically charged, wherein ionically charged means that the total number of electrons of an atom or molecule is not equal to their total number of protons and thus the atom or molecule has a net positive or negative electrical charge,
   - wherein the emitter material is selected from the group of ionic transition metal complex, neutral transition metal complex, polymer emitter and combinations thereof,
   - wherein the matrix material comprises at least one ionic charge carrier transporting material,
   - wherein the ionic charge carrier transporting material is selected from the group of electron-transporting material, hole-transporting material, ambipolar-transporting material and combinations thereof, and
   - wherein the at least one ionic charge carrier transporting material is ionically charged
   - wherein the matrix material and the emitter material are mixed together, and
D) Deposition of at least the functional organic layer via a process, which is selected from the group of spin-coating, doctor balding, slot die coating, screen-printing, flexography printing, gravure printing and inkjet printing and combinations thereof.

The embodiments and definitions, which are described in the description of the organic electroluminescent device, are also valid for the method of producing an organic electroluminescent device and/or vice versa.

In the exemplary embodiments and figures, identical or identically acting constituent parts may be provided in each case with the same reference symbols. The elements illustrated and their size relationships among one another should not in principle be regarded as true to scale; rather, individual elements, such as, for example, layers, structural parts, components and regions, may be illustrated with exaggerated thickness or size dimensions for the sake of better presentation and/or for the sake of better understanding.

In the figures:
- Figure 1: shows a schematic illustration of an organic electroluminescent device according to one embodiment of the invention,
- Figure 2: shows an average voltage U in V and a luminance L in cd/m² as function of time in h of an organic electroluminescent device according to one embodiment of the invention,
- Figure 3: shows an average voltage U in V and a luminance L in cd/m² as function of time in h of an organic electroluminescent device according to one embodiment of the invention,
- Figure 4: shows an average voltage U in V and a luminance L in cd/m² as function of time in h of an organic electroluminescent device according to one embodiment of the invention,
- Figure 5: shows an average voltage U in V and a luminance L in cd/m² as function of time in h of an organic electroluminescent device according to one embodiment of the invention,
- Figure 6: shows an average voltage U in V and a luminance L in cd/m² as function of time in h of an organic electroluminescent device according to one embodiment of the invention,
- Figure 7: shows an average voltage U in V and a luminance L in cd/m² as function of time in h of an organic electroluminescent device according to one exemplary embodiment of the invention,
- Figures 8a to 8f: show different ionic carrier transporting materials according to an embodiment of the invention, and
- Figures 9a to 9s: show different hole-transporting materials, electron-transporting materials and/or ambipolar-transporting (also called bipolar) materials according to an embodiment of the invention.

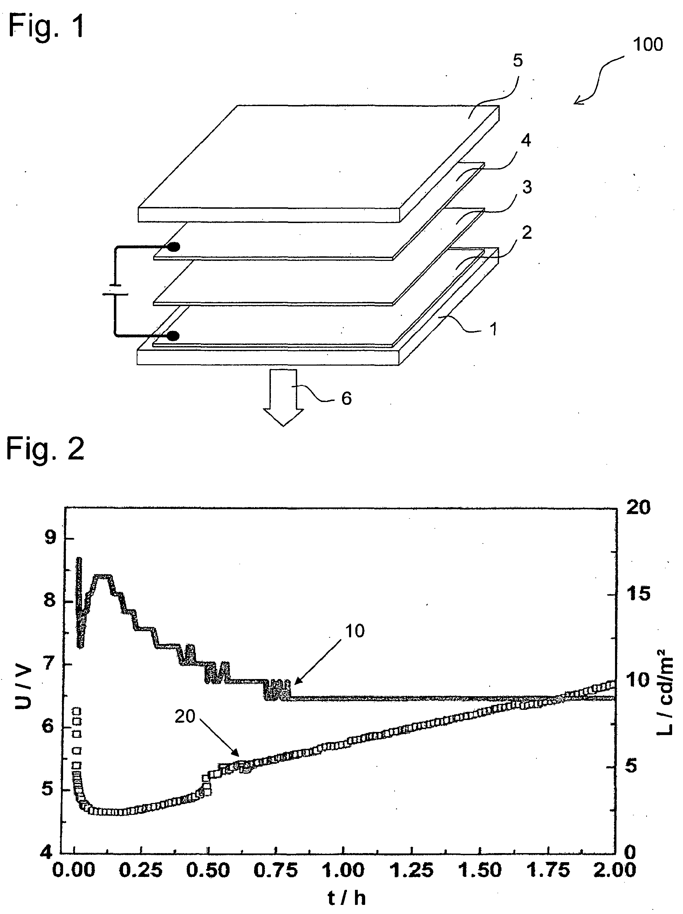

Figure 1 shows a schematic illustration of an organic electroluminescent device according to one embodiment of the invention. The organic electroluminescent device is embodied as an organic light emitting electrochemical cell 100 and comprises a substrate 1, a first electrode 2 arranged on the substrate 1, a functional organic layer 3 arranged on the first electrode 2, a second electrode 4 arranged on the organic functional layer 3 and an encapsulation 5 arranged on the second electrode 4. "Arranged on" means in this case that the layers and/or elements are directly mechanically and/or electrically connected to each other. The functional organic layer 3 comprises an ionic matrix material and an ionic or neutral emitter material (not shown). Additional a salt and/or ionic liquid can be comprised by the functional organic layer 3 (not shown).

Organic light-emitting electrochemical cells 100 have been prepared with the following configuration:
ITO / 1OOnm PEDOT:PSS / EML / 8Onm Al, where ITO is indium tin oxide, PEDOT:PSS is poly(3,4-ethylenedioxythiophene) poly(styrenesulfonate), EML denotes the functional organic layer, which comprises a matrix material and emitter material, and optionally an ionic liquid (IL) 1-butyl-3-methylimidazolium hexafluorophosphate.

In some cases an additional electron blocking layer comprising Poly N-vinylcarbazole (PVK) was employed. The organic layers of PEDOT:PSS and EML have been sequentially deposited on the ITO-glass anode via spin-coating from solution, whereas the Al cathode has been thermally evaporated.

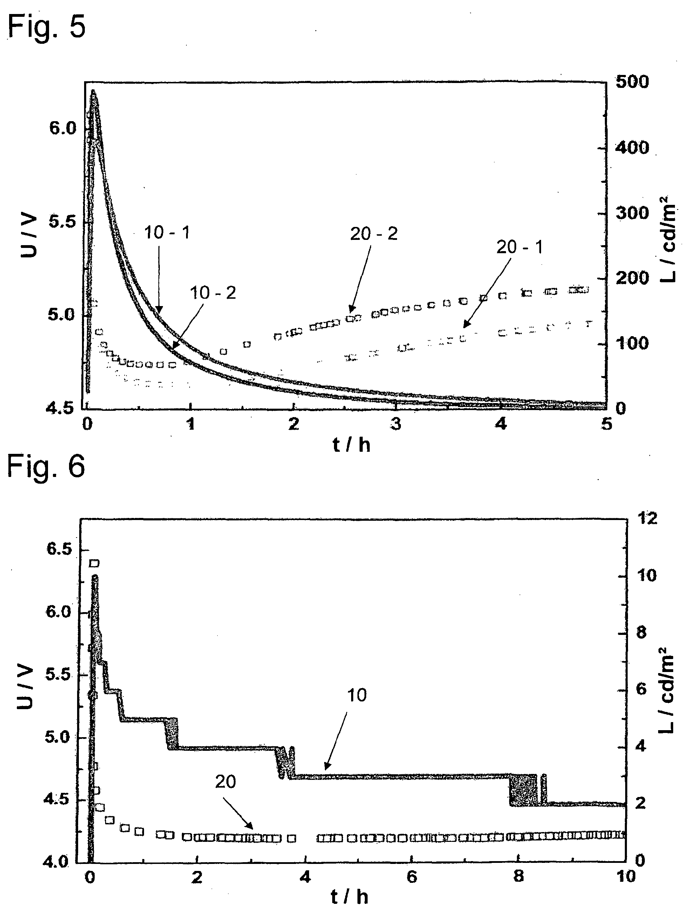

Figures 2 to 7 show each an average voltage U in V (20, symbols) and a luminance L in cd/m² (10, solid line) as function of time in h of an organic electroluminescent device according to one embodiment of the invention. The experiments in Figures 1 to 7 are operated at a pulsed current (1000 Hz, square wave, 30 % duty cycle) with an average current density of 100 A/m2. Figure 5 shows additionally a operation at a pulsed current (1000 Hz, square wave, 30 % duty cycle) with an average current density of 75 A/m2. The solid lines 10-1 and 10-2 in Figure 5 indicate the luminance L in cd/m² as function of time in h at an average current density of 75 A/m² and 100 A/m², respectively. The symbols 20-1 and 20-2 indicate the voltage U in V as function of time in h at an average current density of 75 A/m² and 100 A/m², respectively.

Here and in the following the following abbreviations denote a corresponding material with a structural formula according to the tables below:

### Matrix material

Hole-transporting material:

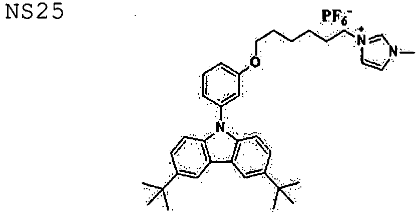

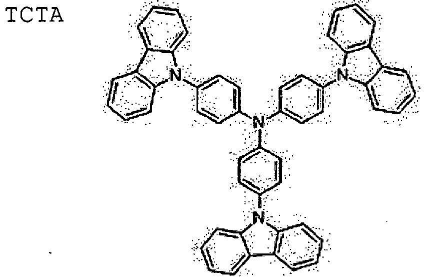

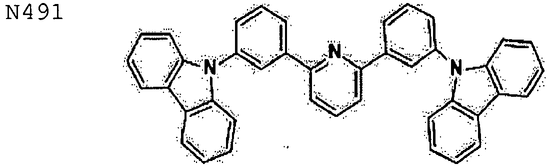

Electron-transporting material:

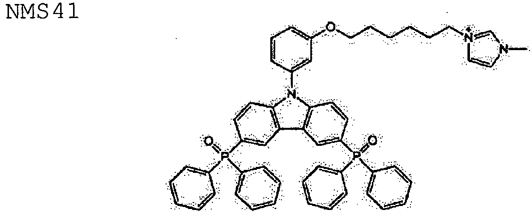

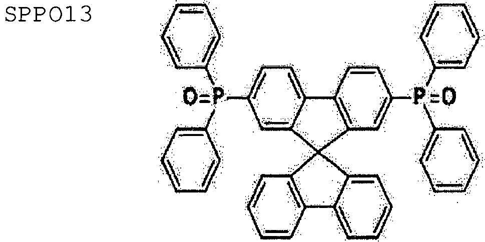

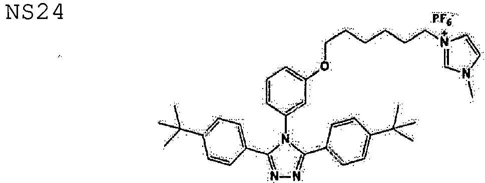

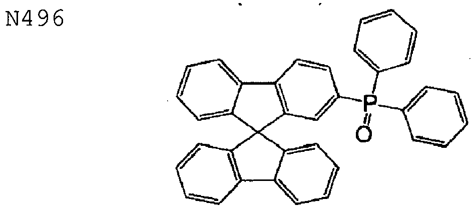

### Emitter material

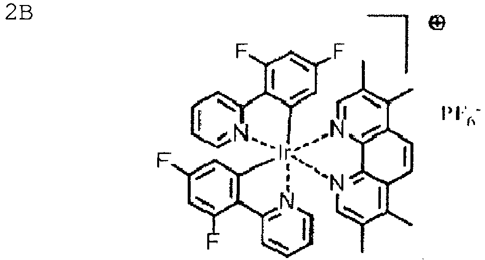

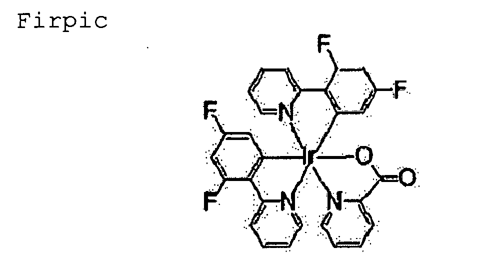

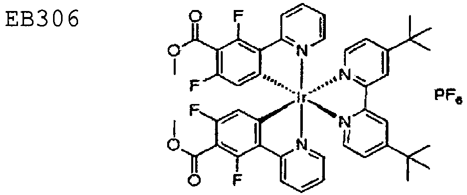

The functional organic layer of Figure 2 comprises the matrix material NMS41 and NS25 in a ratio NMS41:NS25=1:1 in terms of weight and the emitter material 2B. The ratio of the matrix material to the emitter material is 9:1.

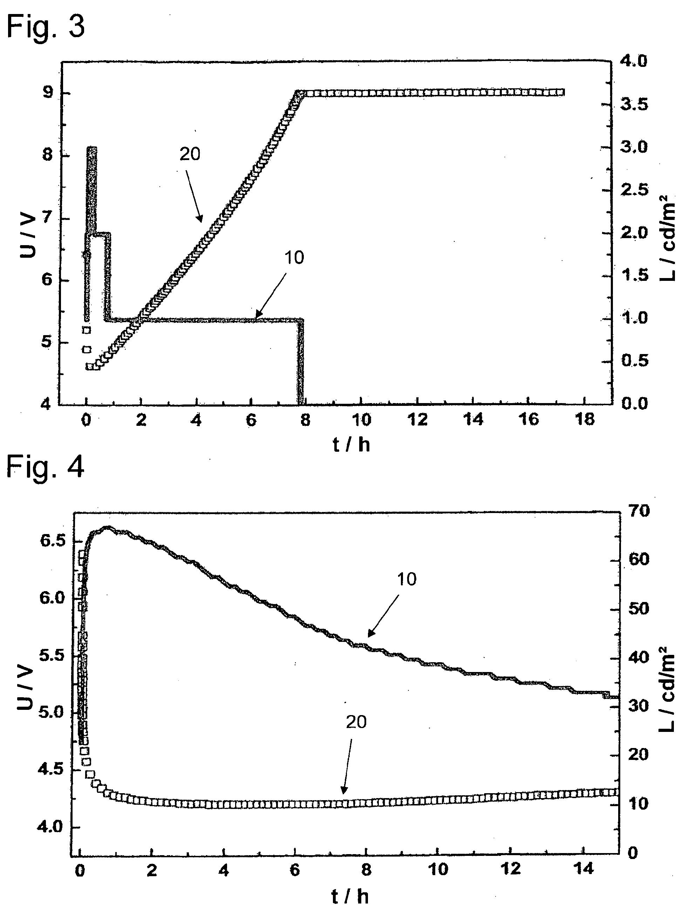

The functional organic layer of Figure 3 comprises the matrix material NMS41 and NS25 in a ratio NMS41:NS25=1:1 in terms of weight and the emitter material Firpic. The ratio of the matrix material to the emitter material is 9:1.

The functional organic layer of Figure 4 comprises the matrix material SPPO13 and NS25 and the emitter material EB306 in a ratio 6.7 : 6.7 : 1.5 in terms of weight. Additionally, the functional organic layer comprises 1-butyl-3-methylimidazolium tetrafluoroborate as an ionic liquid (4:1). Additionally, a electron blocking layer is arranged between PEDOT:PSS and EML.

The functional organic layer of Figure 5 comprises the matrix material SPPO13 and NS25 and the emitter material Firpic in a ratio 6.7 : 6.7 : 1.5 in terms of weight.

The functional organic layer of Figure 6 comprises the matrix material NS24 and TCTA in a ratio 1:1 in terms of weight and the emitter material Firpic. The ratio of the matrix material to the emitter material is 9:1.

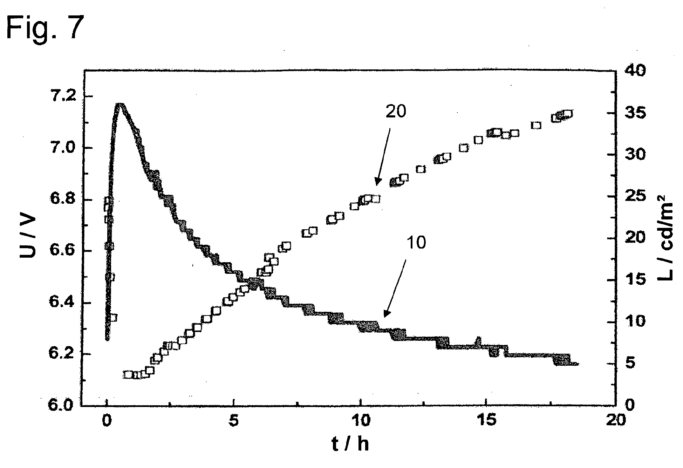

The functional organic layer of Figure 7 comprises the matrix material N491 and N496 and the emitter material EB306. The ratio of the matrix material to the emitter material is 9:1. Additionally, the functional organic layer comprises 1-butyl-3-methylimidazolium hexafluorophosphate as an ionic liquid. Additionally, a electron blocking layer is arranged between PEDOT:PSS and EML.

A comparison of the luminance of Figures 2 to 7 shows that the best results were obtained with a device with the setup: ITO/PEDOT:PSS/SPPOI3:NS25:Firpic 6.7:6.7:1.5/Al (Figure,5) A combination of a neutral electron-transporting material, an ionically charged hole-transporting material with a neutral charged emitter material show the best results of the voltage and luminance behaviour and low turn-on time. In this context, "turn-on time" is defined as the time, which is required to reach the maximum luminance, e.g. 200 cd/m².

It is also possible to prepare an organic light-emitting diode with the following configuration (not shown):

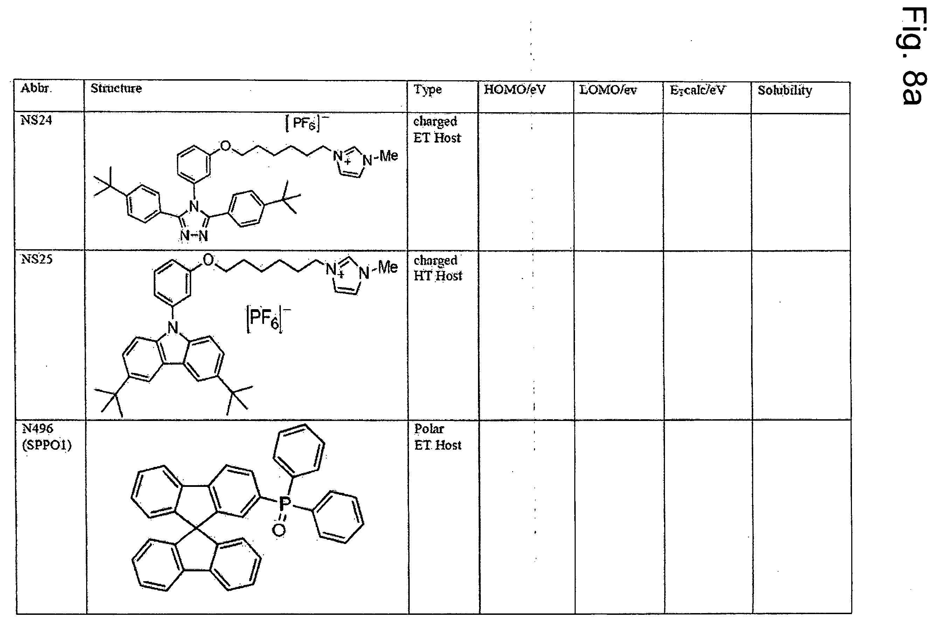

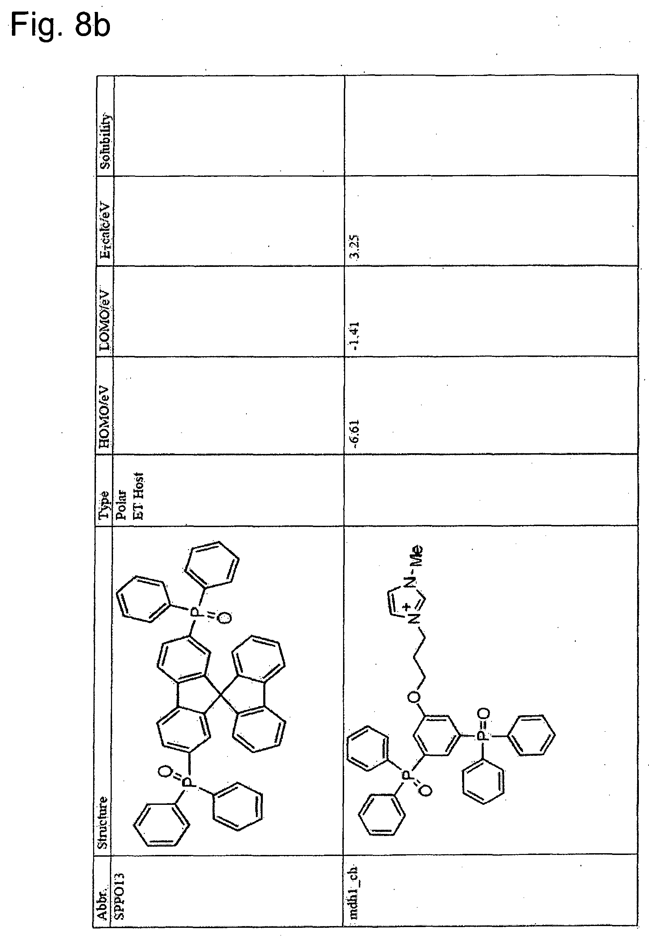

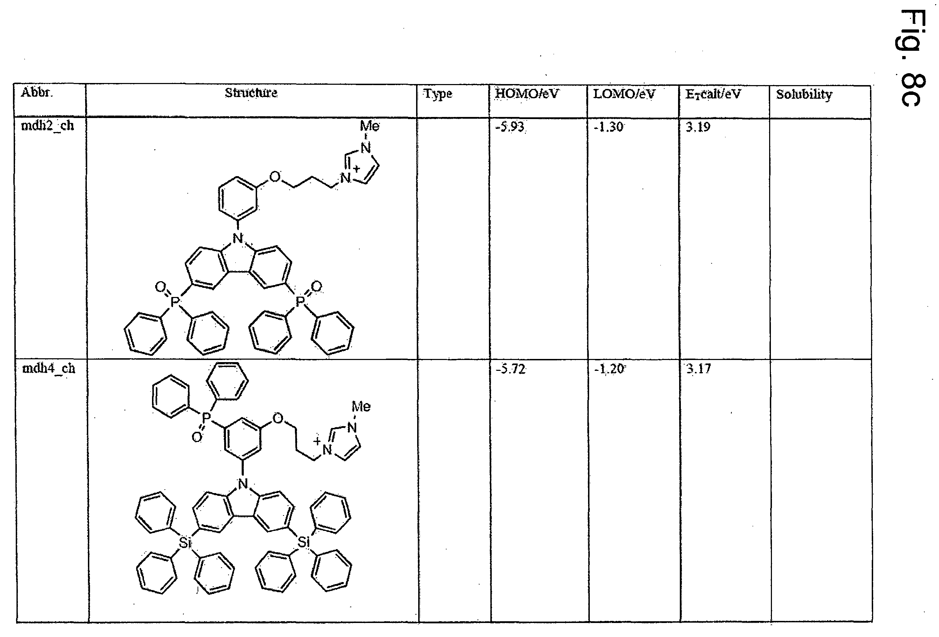

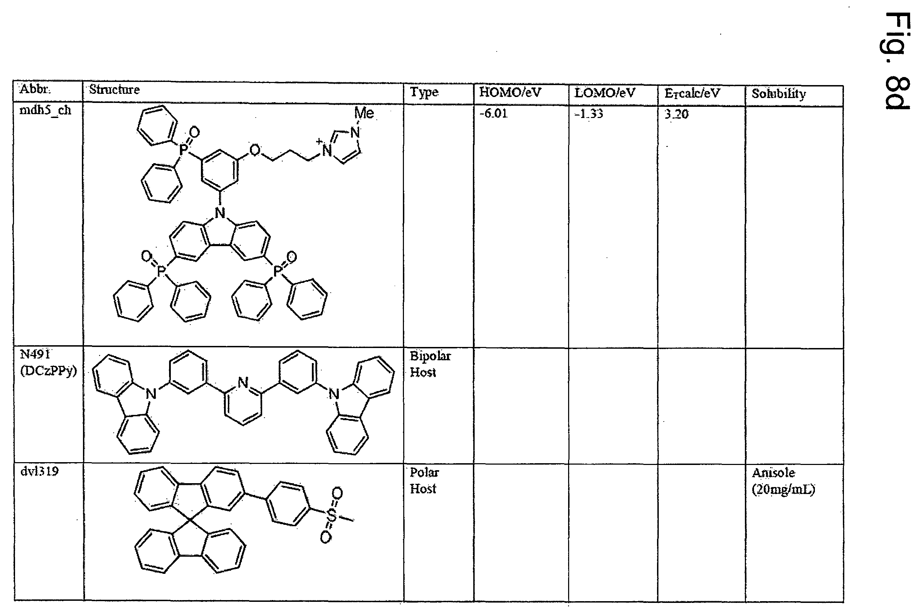

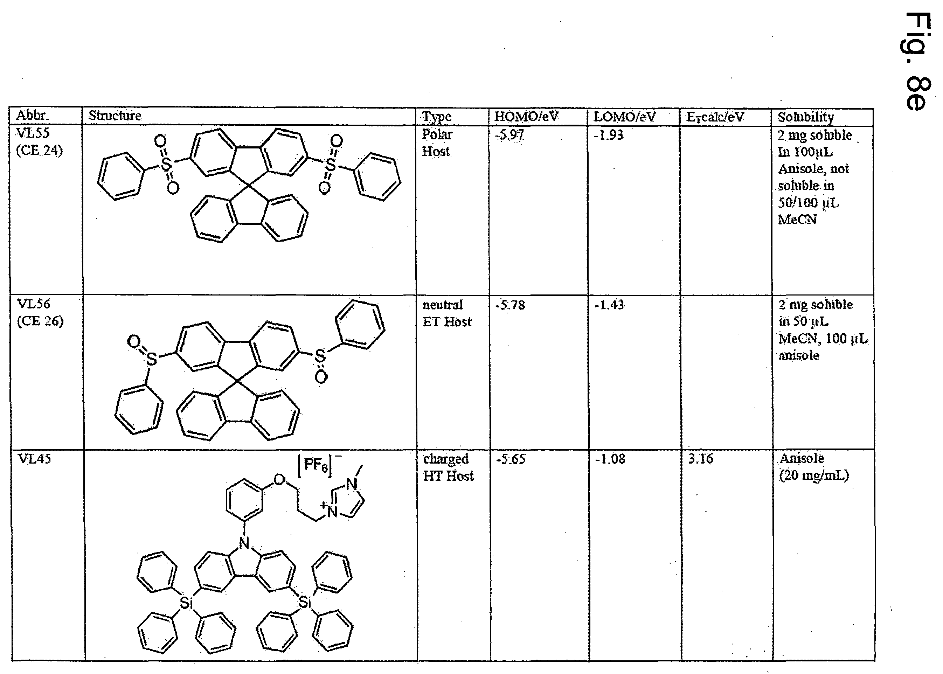

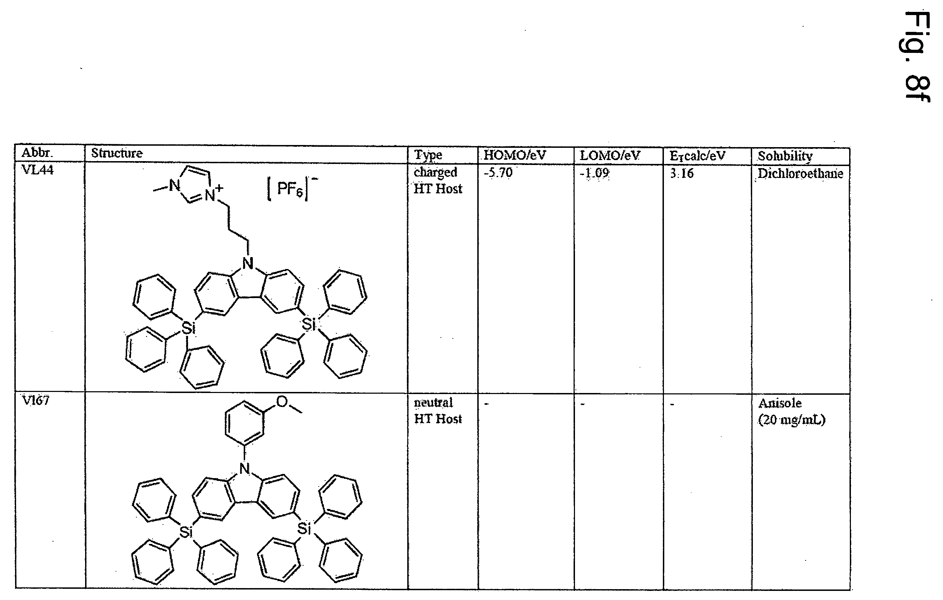

Figures 8a to 8f show different ionic carrier transporting materials according to an embodiment of the invention. ET denotes electron-transporting. HT denotes hole-transporting. HOMO denotes the energy of the highest occupied molecular orbital in eV. LUMO denotes the lowest unoccupied molecular orbital in eV. E_{T} calc stands for triplet energy in eV.

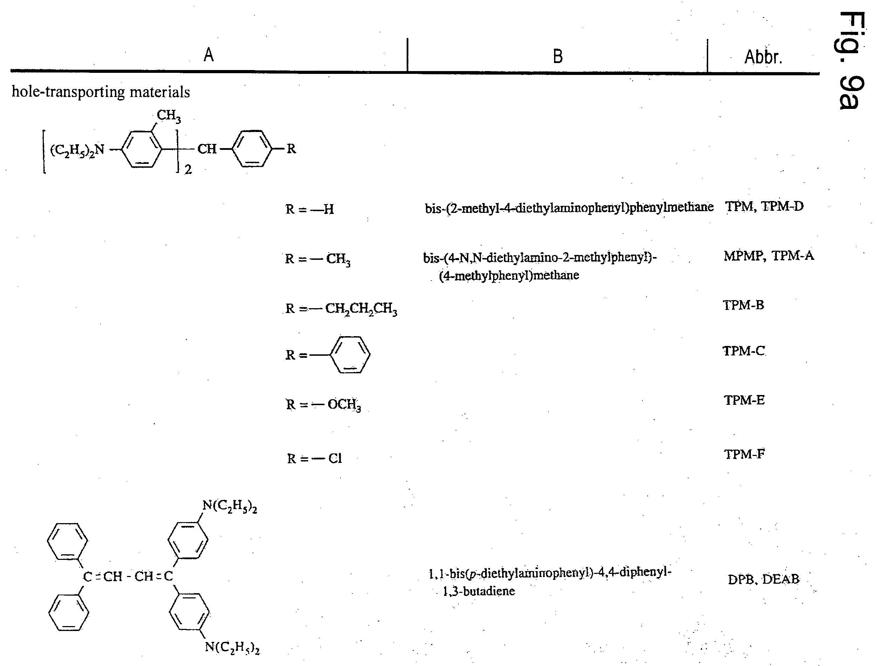

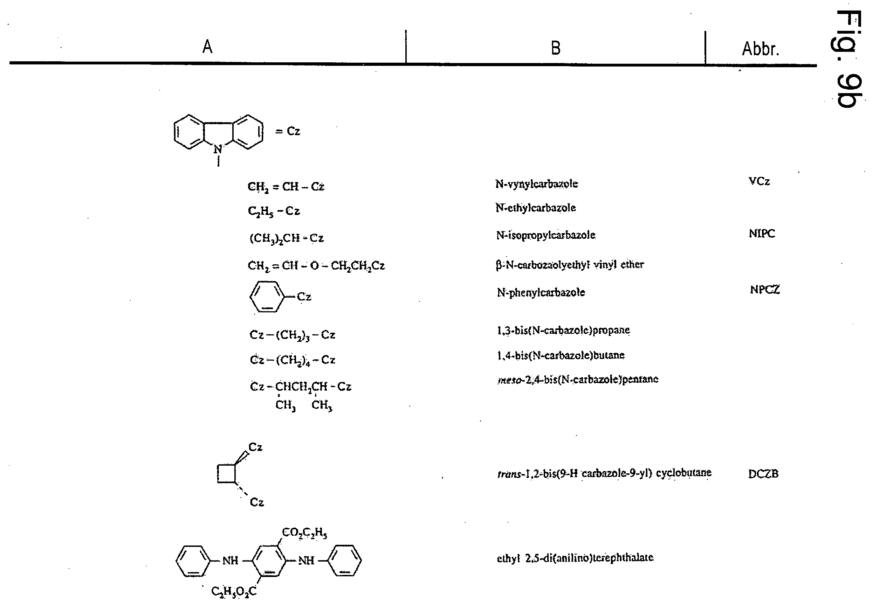

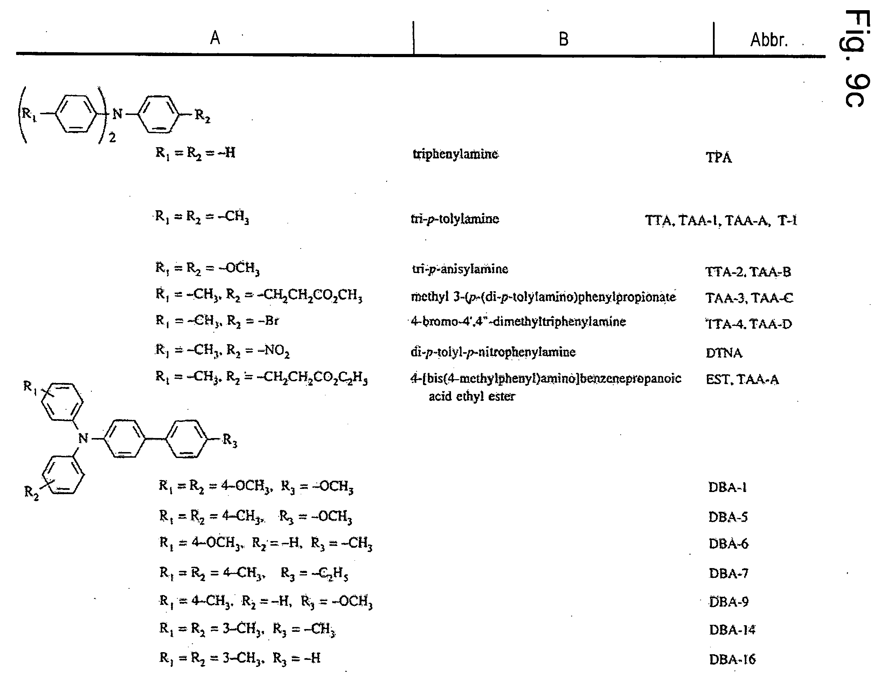

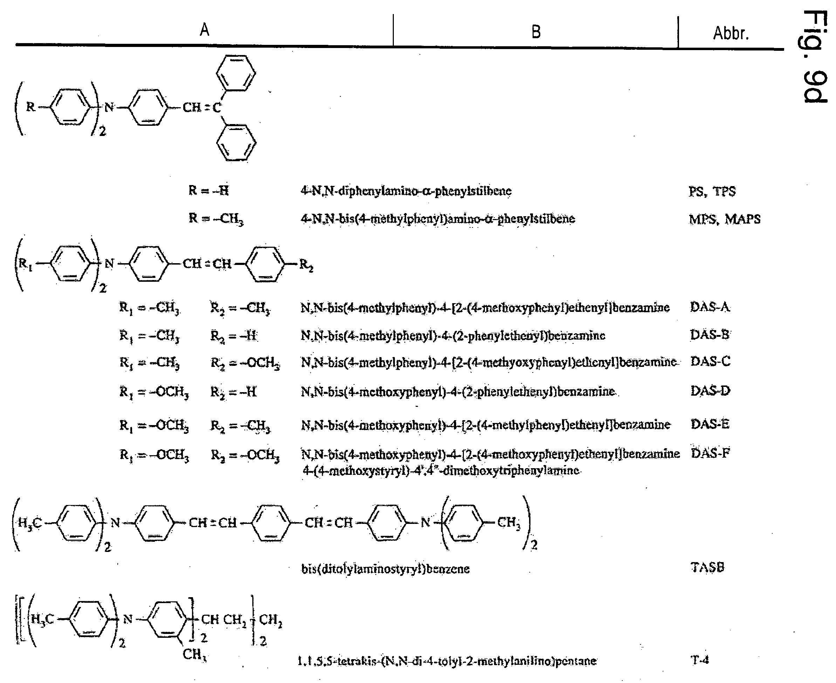

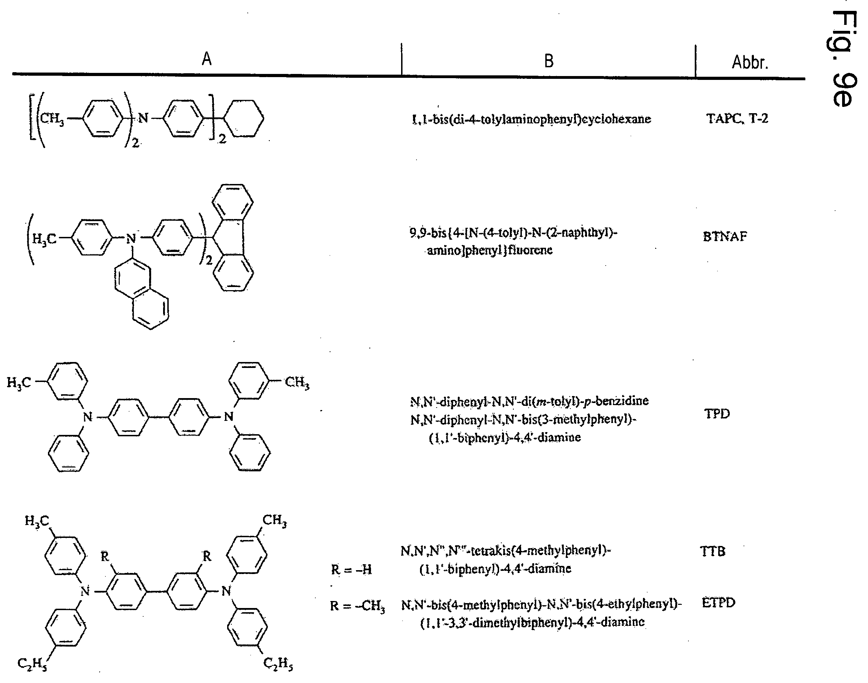

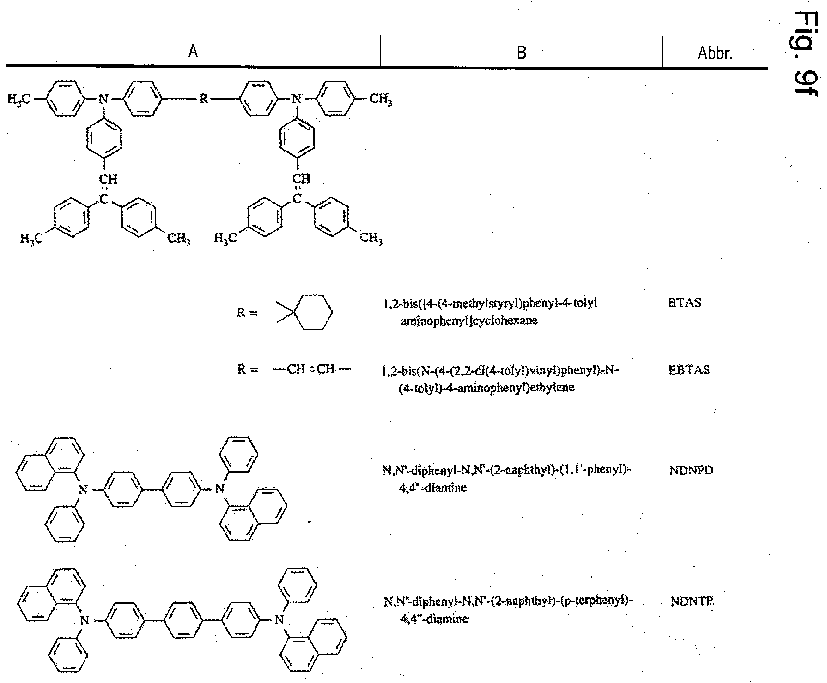

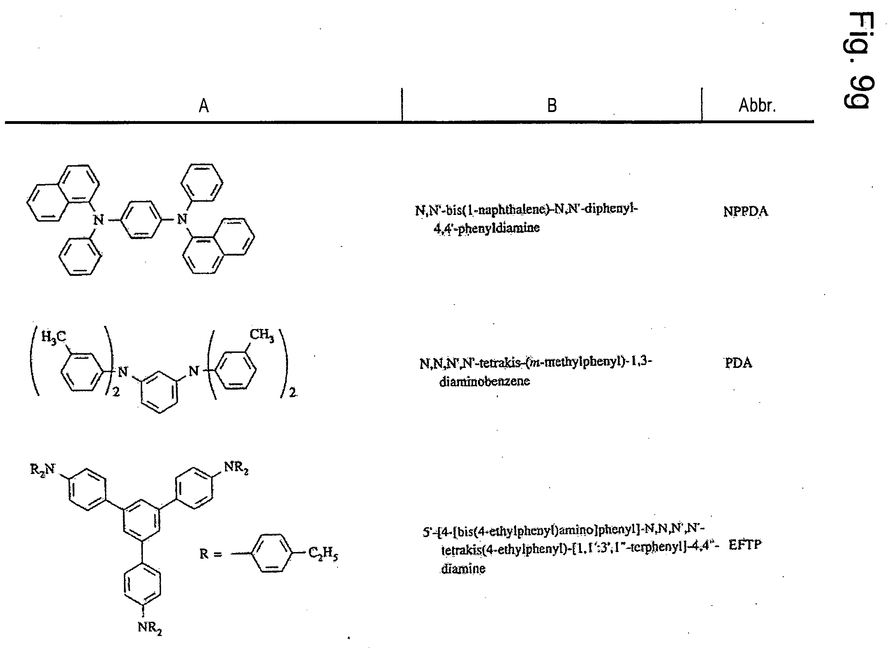

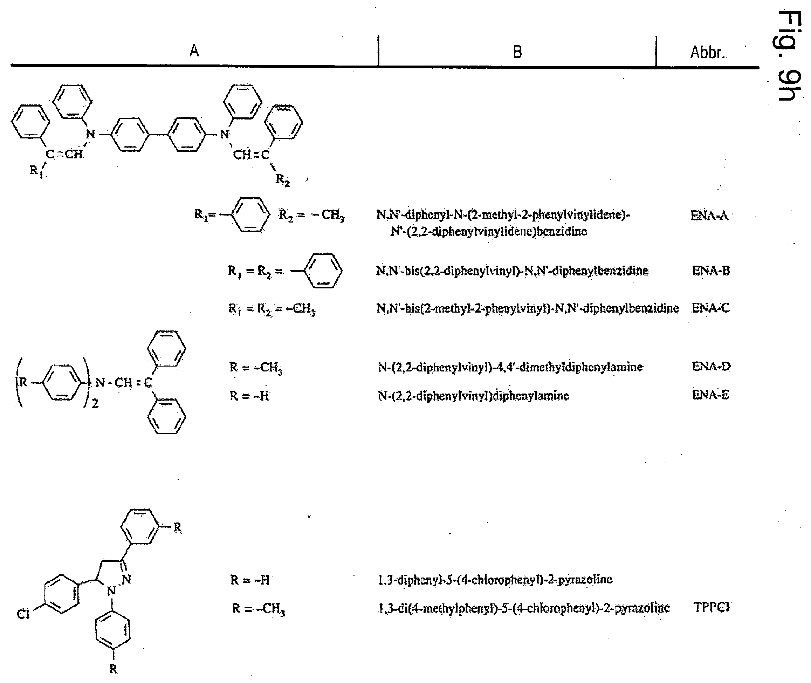

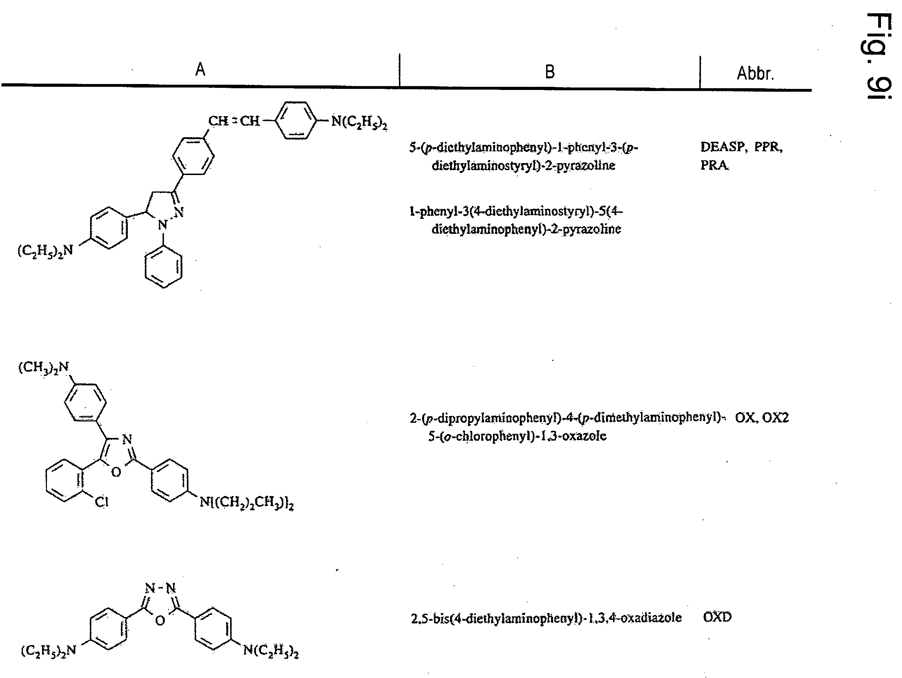

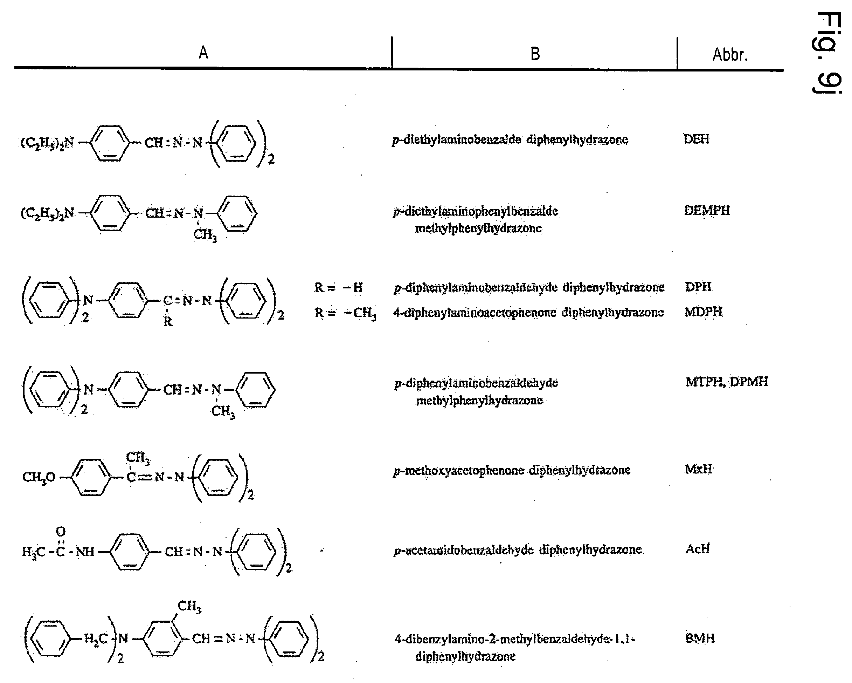

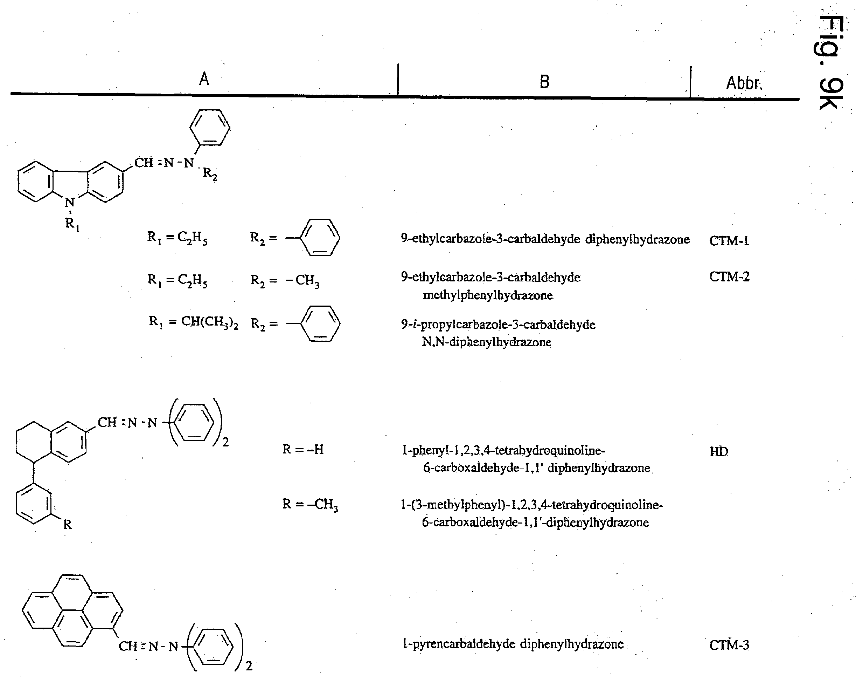

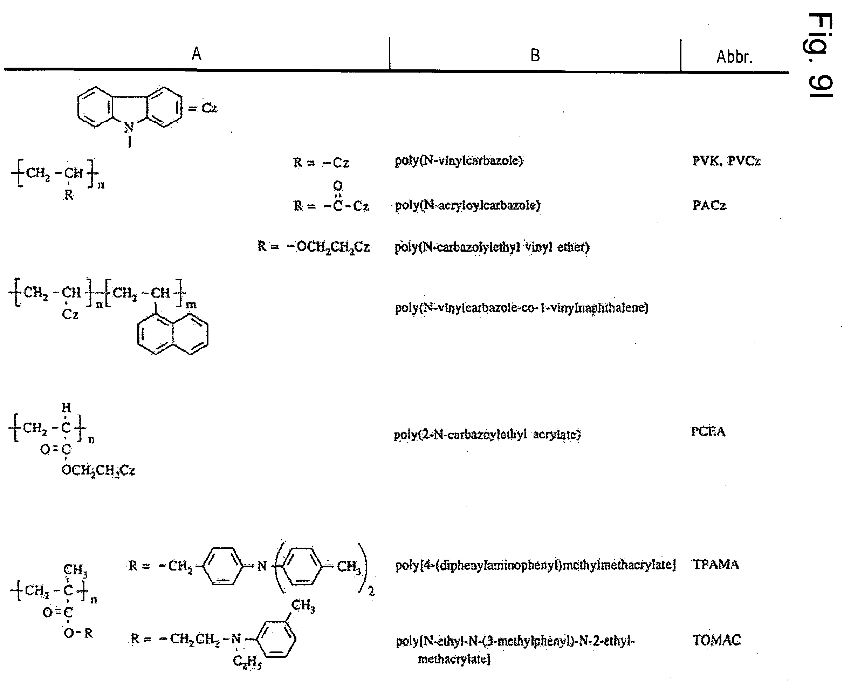

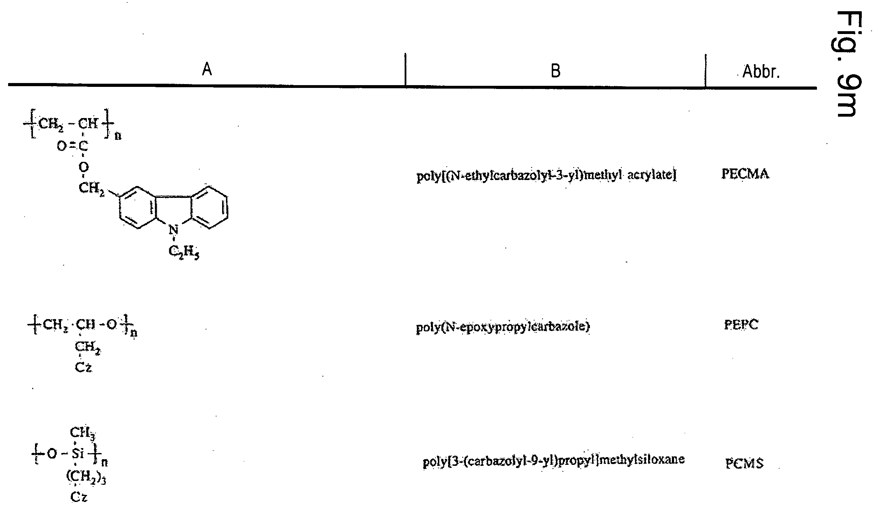

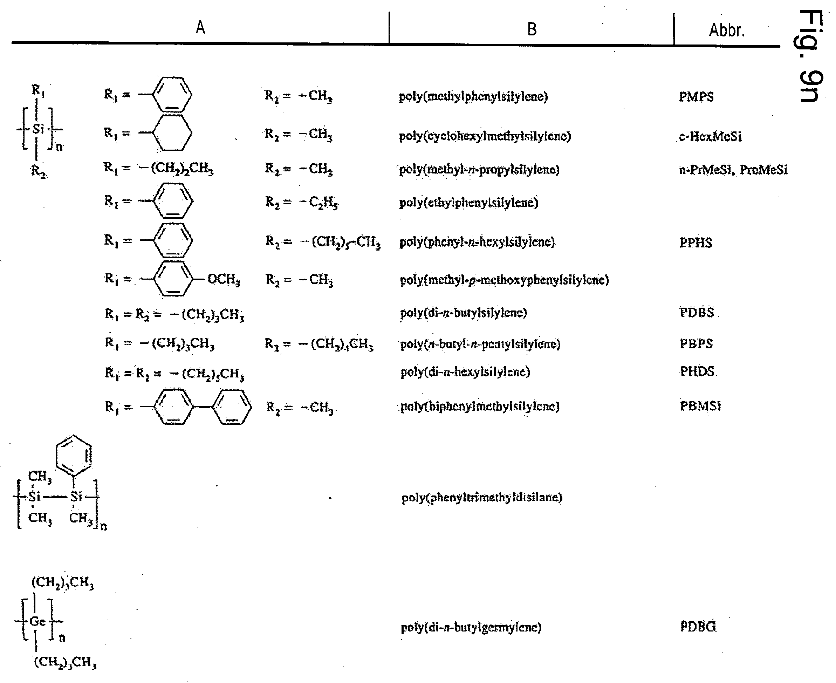

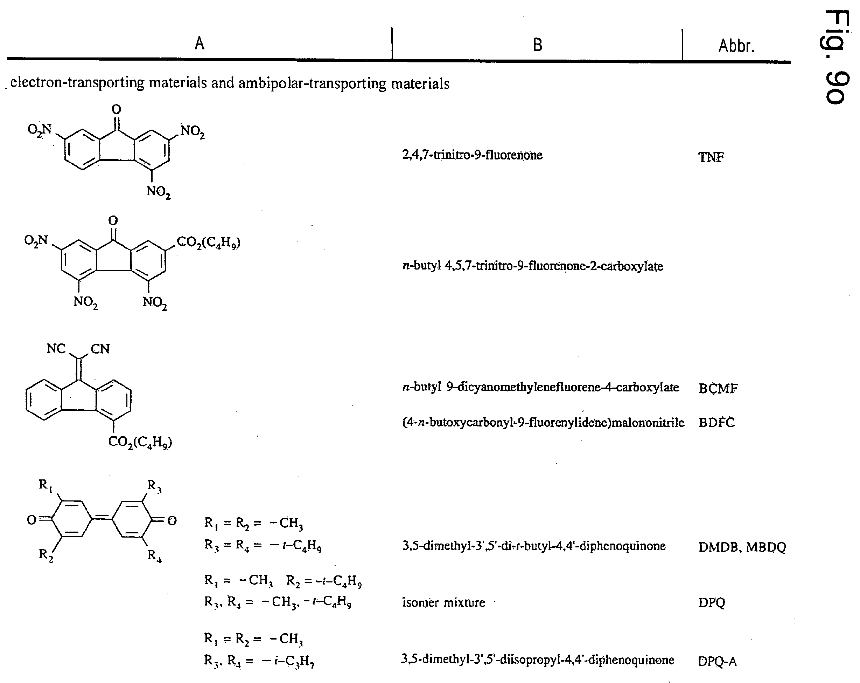

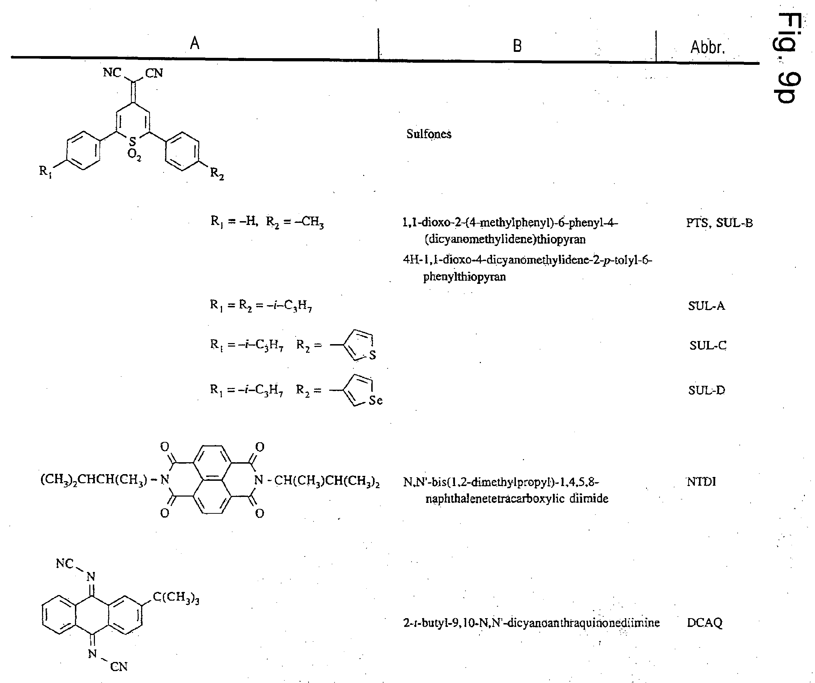

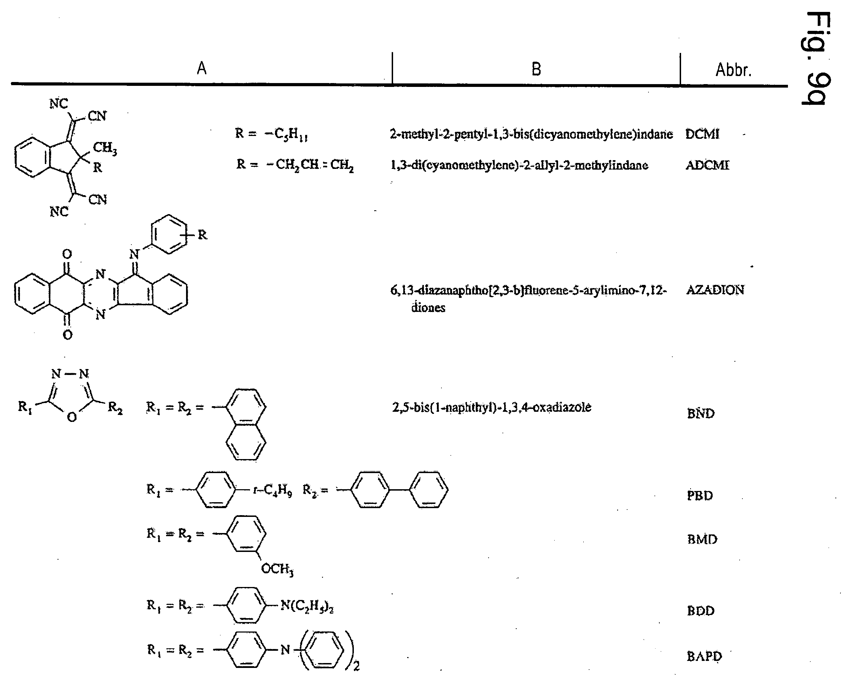

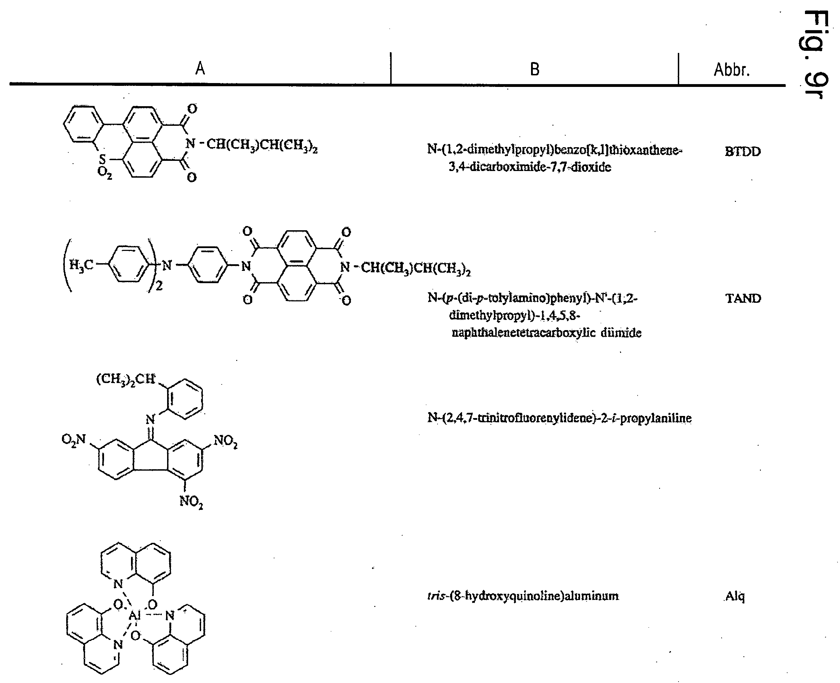

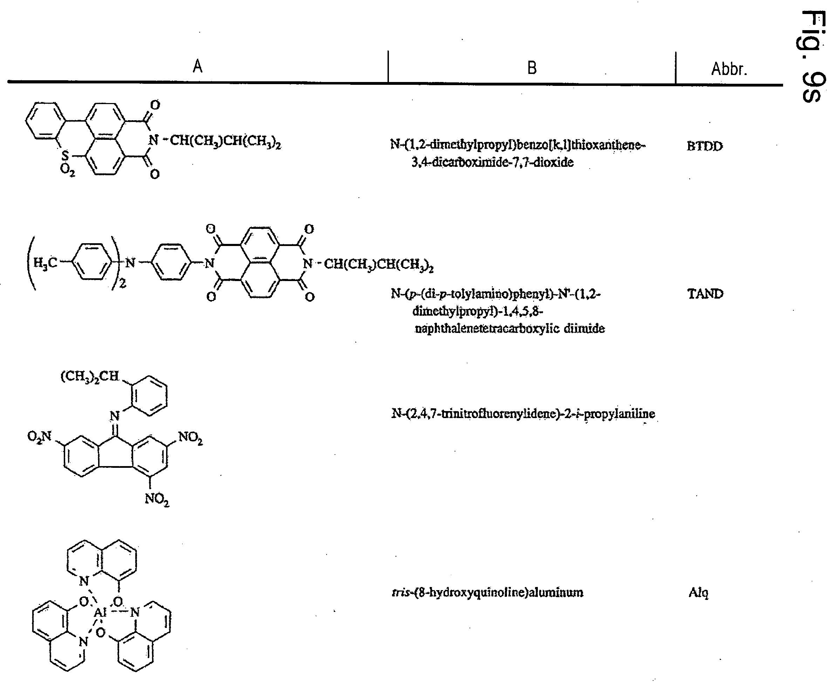

Figures 9a to 9s show the chemical structure (A), the chemical name (B) and the abbreviation (Abbr.) of different hole-transporting materials, electron-transporting materials and/or ambipolar-transporting (also called bipolar) materials according to an embodiment of the invention.

This patent application refers also to the publication Sasabe, H. and Kido, J., Chemistry of Materials Review, 2011, 23, 621-630.

### List of reference symbols

- 100: organic electroluminescent device, organic light emitting electrochemical cell
- 1: substrate
- 2: first electrode
- 3: functional organic layer
- 4: second electrode
- 5: encapsulation
- 6: beam path of the electromagnetic radiation
- 10: luminance
- 20: average voltage
- 10-1: luminance at an average current density of 75 A/m²
- 10-2: luminance at an average current density of 100 A/m²
- 20-1: average voltage at an average current density of 75 A/m²
- 20-2: average voltage at an average current density of 100 A/m²

## Claims

1. An organic electroluminescent device comprising
- a substrate (1),
- a first electrode (2) arranged on the substrate (1),
- a functional organic layer (3) arranged on the first electrode (2), wherein the functional organic layer (3) is adapted to emit electromagnetic radiation,
- a second electrode (4) arranged on the functional organic layer (3),
- wherein the functional organic layer (3) comprises a matrix material and an emitter material,
- wherein the emitter material is neutral or ionically charged,
- wherein the emitter material is selected from the group of ionic transition metal complex, neutral transition metal complex, polymer emitter and combinations thereof,
- wherein the matrix material comprises at least one ionic charge carrier transporting material,
- wherein the ionic charge carrier transporting material is selected from the group of electron-transporting material, hole-transporting material, ambipolar transporting material and combinations thereof and
- wherein the at least one ionic charge carrier transporting material is ionically charged,
wherein ionically charged means that the total number of electrons of an atom or molecule is not equal to their total number of protons and thus the atom or molecule has a net positive or negative electrical charge.

2. The organic electroluminescent device according to the preceding claim, wherein the functional organic layer (3) comprises or consists of an emitter material with the formula 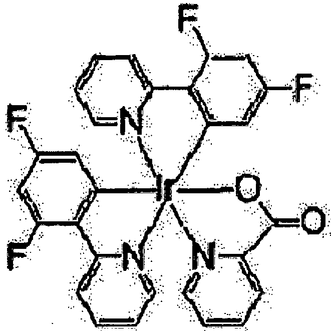 or derivatives thereof and of a hole-transporting material with the formula 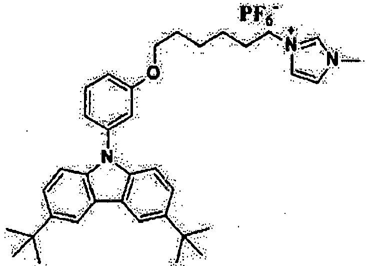 or derivatives thereof and of an electron-transporting material with the formula 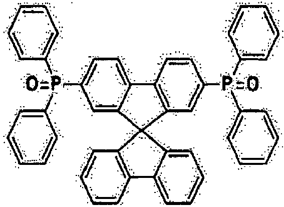 or derivatives thereof.

3. The organic electroluminescent device according to the claim 2, wherein the ratio of electron-transporting material to hole-transporting material to emitter material is equal to 7 to 7 to 2 with a standard deviation of +/- 10 % in terms of weight.

4. The organic electroluminescent device according to one of the preceding claims, wherein the organic electroluminescent device is an organic light emitting electrochemical cell (100).

5. The organic electroluminescent device according to the preceding claims, wherein the functional organic layer (3) is adapted to emit electromagnetic radiation (6) in the blue and/or green spectral range.

6. The organic electroluminescent device according to the preceding claims, wherein the electron-transporting material is ionically charged and the hole-transporting material is ionically charged, or the electron-transporting material is neutral and the hole-transporting material is ionically charged, or the electron-transporting material is ionically charged and the hole-transporting material is neutral.

7. The organic electroluminescent device according to one of the preceding claims, wherein the ionic charge carrier transporting material has a molecular weight of less than 1000 g/mol.

8. The organic electroluminescent device according to one of the preceding claims, wherein the amount of the matrix material in the functional organic layer is more than 60 % in terms of weight.

9. The organic electroluminescent device according to claim 1, wherein the emitter material is ionically charged.

10. The organic electroluminescent device according to one of the preceding claims, wherein the matrix material comprises an additional material, wherein the additional material is neutral or ionically charged, wherein the additional material comprises at least one polymer, and/or salt and/or ionic liquid.

11. The organic electroluminescent device according to one of the preceding claims, wherein the electron-transporting material is selected from the group comprising materials with one of the following structural formulae and derivatives and combinations thereof: 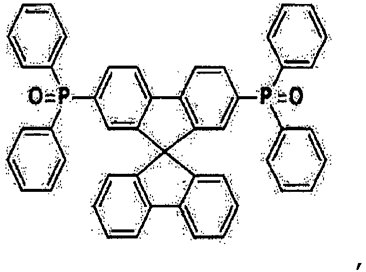 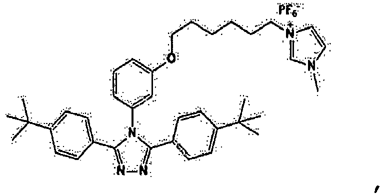 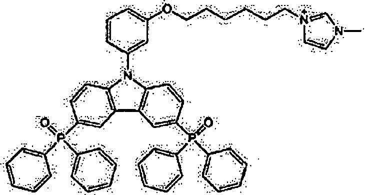 and

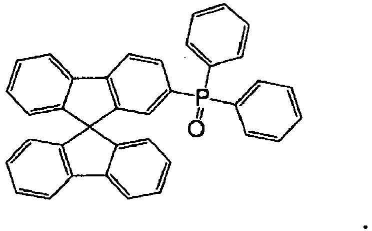

12. The organic electroluminescent device according to one of the preceding claims, wherein the hole-transporting material is selected from the group of materials comprising one of the following structural formulae and derivatives and combinations thereof: 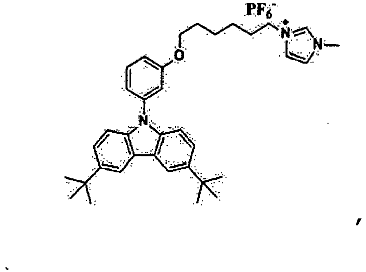 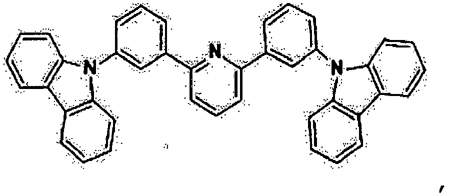 and

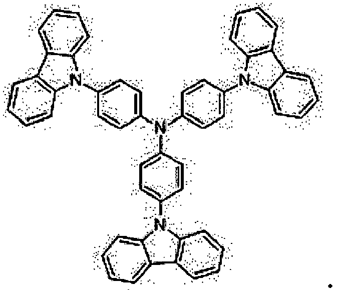

13. The organic electroluminescent device according to one of the preceding claims, wherein the emitter material comprises a transition metal, wherein the transition metal is selected from the group including a transition metal of the platinum group of the periodic table and a transition metal of the copper group of the periodic table.

14. The organic electroluminescent device according to one of the preceding claims comprises an electron blocking layer, which is arranged above the first electrode (2).

15. The organic electroluminescent device according to one of the preceding claims comprising a hole blocking layer, which is arranged below the second electrode (4).

16. The organic electroluminescent device according to one of the preceding claims comprising one further functional organic layer or a plurality of further functional organic layers, wherein the functional organic layer (3) and at least one further functional organic layer are stacked.

17. The organic electroluminescent device according to claim 16, wherein the functional organic layer (3) and/or at least one further functional organic layer are neighboured in a stack by at least one additional functional layer, wherein the additional functional layers are selected from the group of electron-transporting materials, electron-injecting materials, hole-transporting materials, hole-injecting materials and combinations thereof.

18. A method of producing an organic electroluminescent device according to one of claims 1 to 17 with the following process steps:
A) Provision of a substrate (1),
B) Provision of a first electrode (2) and a second electrode (4),
C) Provision of a functional organic layer (3),
- wherein the functional organic layer (3) is adapted to emit electromagnetic radiation,
- wherein the functional organic layer (3) comprises a matrix material and an emitter material,
- wherein the emitter material is neutral or ionically charged, wherein ionically charged means that the total number of electrons of an atom or molecule is not equal to their total number of protons and thus the atom or molecule has a net positive or negative electrical charge,
- wherein the emitter material is selected from the group of ionic transition metal complex, neutral transition metal complex, polymer emitter and combinations thereof,
- wherein the matrix material comprises at least one ionic charge carrier transporting material,
- wherein the ionic charge carrier transporting material is selected from the group of electron-transporting material, hole-transporting material, ambipolar-transporting material and combinations thereof and
- wherein the at least one ionic charge carrier transporting material is ionically charged,
- wherein the matrix material and the emitter material are mixed together, and
D) Deposition of at least the functional organic layer (3) via a process, which is selected from the group of spin-coating, doctor blading, slot die coating, screen-printing, flexography printing, gravure printing and inkjet printing and combinations thereof.

## Patentansprüche

1. Organisches Elektrolumineszenzbauelement, das Folgendes umfasst:
- ein Substrat (1),
- eine erste Elektrode (2), die auf dem Substrat (1) angeordnet ist,
- eine funktionale organische Schicht (3), die auf der ersten Elektrode (2) angeordnet ist, wobei die funktionale organische Schicht (3) zur Emission von elektromagnetischer Strahlung eingerichtet ist,
- eine zweite Elektrode (4), die auf der funktionalen organischen Schicht (3) angeordnet ist,
- wobei die funktionale organische Schicht (3) ein Matrixmaterial und ein Emittermaterial umfasst,
- wobei das Emittermaterial neutral oder ionisch geladen ist,
- wobei das Emittermaterial ausgewählt ist aus der Gruppe von ionischem Übergangsmetallkomplex, neutralem Übergangsmetallkomplex, Polymeremitter und Kombinationen davon,
- wobei das Matrixmaterial mindestens ein Ionenladungsträger transportierendes Material umfasst,
- wobei das Ionenladungsträger transportierende Material ausgewählt ist aus der Gruppe von Elektronen transportierendem Material, Loch transportierendem Material, ambipolarem transportierendem Material und Kombinationen davon, und
- wobei das mindestens eine Ionenladungsträger transportierende Material ionisch geladen ist, wobei ionisch geladen bedeutet, dass die Gesamtzahl an Elektronen eines Atoms oder Moleküls nicht gleich ihrer Gesamtzahl an Protonen ist und somit das Atom oder das Molekül eine positive oder negative elektrische Nettoladung aufweist.

2. Organisches Elektrolumineszenzbauelement nach dem vorhergehenden Anspruch, wobei die funktionale organische Schicht (3) ein Emittermaterial mit der Formel 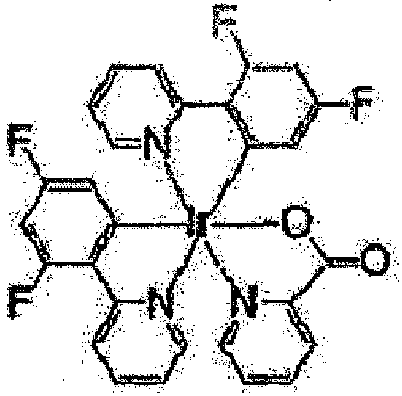 oder Derivate davon und ein Loch transportierendes Material mit der Formel 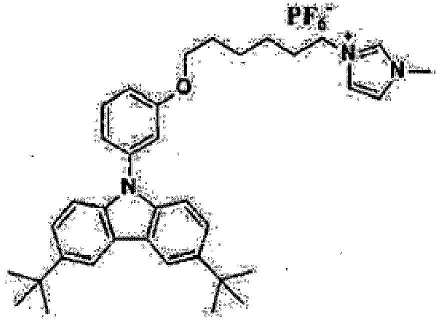 oder Derivate davon und ein Elektronen transportierendes Material mit der Formel 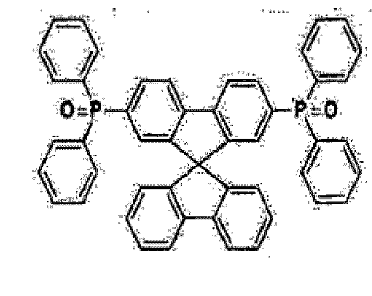 oder Derivate davon umfasst oder daraus besteht.

3. Organisches Elektrolumineszenzbauelement nach Anspruch 2, wobei das Verhältnis aus Elektronen transportierendem Material zu Loch transportierendem Material zu Emittermaterial gleich 7 zu 7 zu 2 bei einer Standardabweichung von +/-10% bezüglich Gewicht ist.

4. Organisches Elektrolumineszenzbauelement nach einem der vorhergehenden Ansprüche, wobei das organische Elektrolumineszenzbauelement eine organische lichtemittierende elektrochemische Zelle (100) ist.

5. Organisches Elektrolumineszenzbauelement nach den vorhergehenden Ansprüchen, wobei die funktionale organische Schicht (3) zur Emission von elektromagnetischer Strahlung (6) im blauen und/oder grünen Spektralbereich eingerichtet ist.

6. Organisches Elektrolumineszenzbauelement nach den vorhergehenden Ansprüchen, wobei das Elektronen transportierende Material ionisch geladen ist und das Loch transportierende Material ionisch geladen ist oder das Elektronen transportierende Material neutral ist und das Loch transportierende Material ionisch geladen ist oder das Elektronen transportierende Material ionisch geladen ist und das Loch transportierende Material neutral ist.

7. Organisches Elektrolumineszenzbauelement nach einem der vorhergehenden Ansprüche, wobei das Ionenladungsträger transportierende Material ein Molekulargewicht von unter 1000 g/mol aufweist.

8. Organisches Elektrolumineszenzbauelement nach einem der vorhergehenden Ansprüche, wobei die Menge des Matrixmaterials in der funktionalen organischen Schicht über 60% bezüglich Gewicht beträgt.

9. Organisches Elektrolumineszenzbauelement nach Anspruch 1, wobei das Emittermaterial ionisch geladen ist.

10. Organisches Elektrolumineszenzbauelement nach einem der vorhergehenden Ansprüche, wobei das Matrixmaterial ein zusätzliches Material umfasst, wobei das zusätzliche Material neutral oder ionisch geladen ist, wobei das zusätzliche Material mindestens ein Polymer und/oder Salz und/oder eine ionische Flüssigkeit umfasst.

11. Organisches Elektrolumineszenzbauelement nach einem der vorhergehenden Ansprüche, wobei das Elektronen transportierende Material ausgewählt ist aus der Gruppe umfassend Materialien mit einer der folgenden Strukturformeln und Derivate und Kombinationen davon: 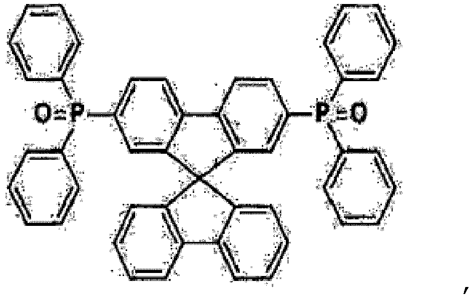 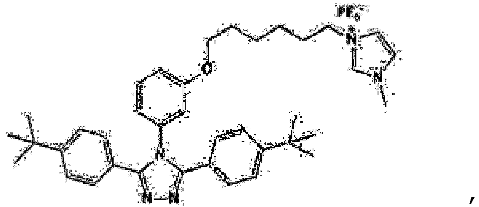 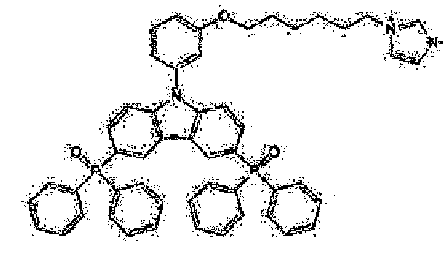 und

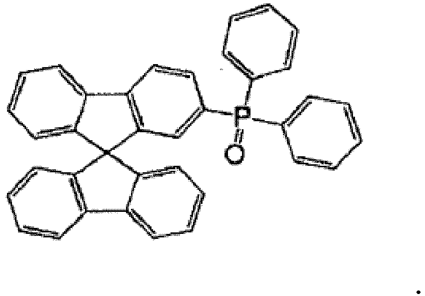

12. Organisches Elektrolumineszenzbauelement nach einem der vorhergehenden Ansprüche, wobei das Loch transportierende Material ausgewählt ist aus der Gruppe umfassend Materialien mit einer der folgenden Strukturformeln und Derivate und Kombinationen davon: 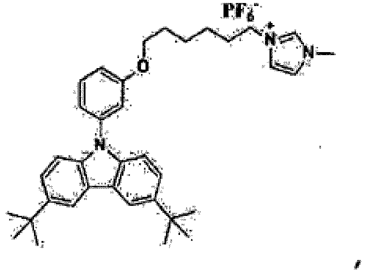 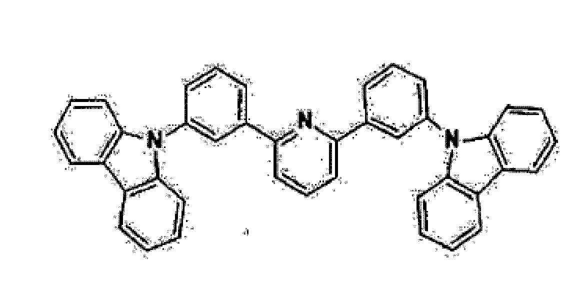 und

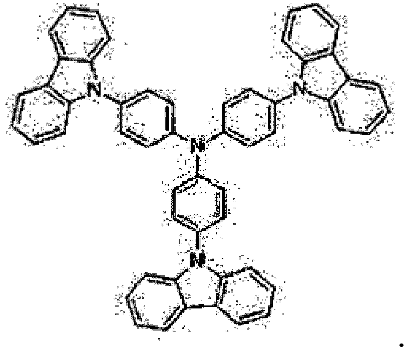

13. Organisches Elektrolumineszenzbauelement nach einem der vorhergehenden Ansprüche, wobei das Emittermaterial ein Übergangsmetall umfasst, wobei das Übergangsmetall ausgewählt ist aus der Gruppe enthaltend ein Übergangsmetall der Platingruppe des Periodensystems der Elemente und ein Übergangsmetall der Kupfergruppe des Periodensystems der Elemente.

14. Organisches Elektrolumineszenzbauelement nach einem der vorhergehenden Ansprüche, das eine Elektronen blockierende Schicht umfasst, die über der ersten Elektrode (2) angeordnet ist.

15. Organisches Elektrolumineszenzbauelement nach einem der vorhergehenden Ansprüche umfassend eine Loch blockierende Schicht, die unter der zweiten Elektrode (4) angeordnet ist.

16. Organisches Elektrolumineszenzbauelement nach einem der vorhergehenden Ansprüche umfassend eine weitere funktionale organische Schicht oder mehrere weitere funktionale organische Schichten, wobei die funktionale organische Schicht (3) und mindestens eine weitere funktionale organische Schicht gestapelt sind.

17. Organisches Elektrolumineszenzbauelement nach Anspruch 16, wobei die funktionale organische Schicht (3) und/oder mindestens eine weitere funktionale organische Schicht in einem Stapel um mindestens eine zusätzliche funktionale Schicht benachbart sind, wobei die zusätzlichen funktionalen Schichten ausgewählt sind aus der Gruppe von Elektronen transportierenden Materialien, Elektronen injizierenden Materialien, Loch transportierenden Materialien, Loch injizierenden Materialien und Kombinationen davon.

18. Verfahren zum Herstellen eines organischen Elektrolumineszenzbauelements nach einem der Ansprüche 1 bis 17 mit den folgenden Prozessschritten:
A) Bereitstellen eines Substrats (1),
B) Bereitstellen einer ersten Elektrode (2) und einer zweiten Elektrode (4),
C) Bereitstellen einer funktionalen organischen Schicht (3),
- wobei die funktionale organische Schicht (3) zur Emission von elektromagnetischer Strahlung eingerichtet ist,
- wobei die funktionale organische Schicht (3) ein Matrixmaterial und ein Emittermaterial umfasst,
- wobei das Emittermaterial neutral oder ionisch geladen ist, wobei ionisch geladen bedeutet, dass die Gesamtzahl an Elektronen eines Atoms oder Moleküls nicht gleich ihrer Gesamtzahl an Protonen ist und somit das Atom oder das Molekül eine positive oder negative elektrische Nettoladung aufweist,
- wobei das Emittermaterial ausgewählt ist aus der Gruppe von ionischem Übergangsmetallkomplex, neutralem Übergangsmetallkomplex, Polymeremitter und Kombinationen davon,
- wobei das Matrixmaterial mindestens ein Ionenladungsträger transportierendes Material umfasst,
- wobei das Ionenladungsträger transportierende Material ausgewählt ist aus der Gruppe von Elektronen transportierendem Material, Loch transportierendem Material, ambipolarem transportierendem Material und Kombinationen davon, und
- wobei das mindestens eine Ionenladungsträger transportierende Material ionisch geladen ist,
- wobei das Matrixmaterial und das Emittermaterial miteinander vermischt werden, und
D) Abscheiden mindestens der funktionalen organischen Schicht (3) über einen Prozess, der ausgewählt ist aus der Gruppe von Aufschleudern, Raken, Schlitzdüsenbeschichtung, Siebdruck, Flexodruck, Tiefdruck und Tintenstrahldruck und Kombinationen davon.

## Revendications

1. Dispositif électroluminescent organique comprenant
- un substrat (1),
- une première électrode (2) disposée sur le substrat (1),
- une couche organique fonctionnelle (3) disposée sur la première électrode (2), la couche organique fonctionnelle (3) étant adaptée pour émettre un rayonnement électromagnétique,
- une deuxième électrode (4) disposée sur la couche organique fonctionnelle (3),
- la couche organique fonctionnelle (3) comprenant un matériau matriciel et un matériau émetteur,
- le matériau émetteur étant neutre ou chargé ioniquement,
- le matériau émetteur étant choisi dans le groupe constitué par un complexe de métal de transition ionique, un complexe de métal de transition neutre, un émetteur polymère et les combinaisons de ceux-ci,
- le matériau matriciel comprenant au moins un matériau de transport porteur de charges ioniques,
- le matériau de transport porteur de charges ioniques étant choisi dans le groupe constitué par un matériau de transport d'électrons, un matériau de transport de trous, un matériau de transport ambipolaire et les combinaisons de ceux-ci, et
- l'au moins un matériau de transport porteur de charges ioniques étant chargé ioniquement, chargé ioniquement signifiant que le nombre total d'électrons d'un atome ou d'une molécule n'est pas égal à leur nombre total de protons et l'atome ou la molécule a ainsi une charge électrique nette positive ou négative.

2. Dispositif électroluminescent organique selon la revendication précédente, dans lequel la couche organique fonctionnelle (3) comprend ou consiste en un matériau émetteur répondant à la formule 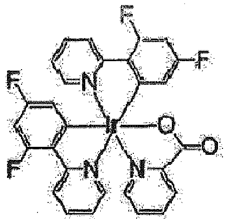 ou les dérivés de celui-ci et un matériau de transport de trous répondant à la formule 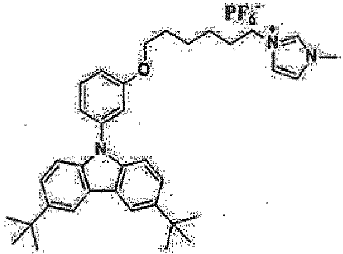 ou les dérivés de celui-ci et un matériau de transport d'électrons répondant à la formule 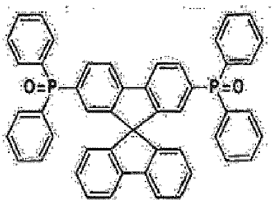 ou les dérivés de celui-ci.

3. Dispositif électroluminescent organique selon la revendication 2, dans lequel le rapport du matériau de transport d'électrons au matériau de transport de trous au matériau émetteur est égal à 7 à 7 à 2 avec un écart type de ± 10 % en poids.

4. Dispositif électroluminescent organique selon une des revendications précédentes, le dispositif électroluminescent organique étant une cellule électrochimique émettrice de lumière organique (100).

5. Dispositif électroluminescent organique selon les revendications précédentes, dans lequel la couche organique fonctionnelle (3) est adaptée pour émettre un rayonnement électromagnétique (6) dans le domaine spectral bleu et/ou vert.

6. Dispositif électroluminescent organique selon les revendications précédentes, dans lequel le matériau de transport d'électrons est chargé ioniquement et le matériau de transport de trous est chargé ioniquement, ou le matériau de transport d'électrons est neutre et le matériau de transport de trous est chargé ioniquement, ou le matériau de transport d'électrons est chargé ioniquement et le matériau de transport de trous est neutre.

7. Dispositif électroluminescent organique selon une des revendications précédentes, dans lequel le matériau de transport porteur de charges ioniques a un poids moléculaire inférieur à 1000 g/mol.

8. Dispositif électroluminescent organique selon une des revendications précédentes, dans lequel la quantité du matériau matriciel dans la couche organique fonctionnelle est supérieure à 60 % en poids.

9. Dispositif électroluminescent organique selon la revendication 1, dans lequel le matériau émetteur est chargé ioniquement.

10. Dispositif électroluminescent organique selon une des revendications précédentes, dans lequel le matériau matriciel comprend un matériau supplémentaire, le matériau supplémentaire étant neutre ou chargé ioniquement, le matériau supplémentaire comprenant au moins un polymère, et/ou un sel, et/ou un liquide ionique.

11. Dispositif électroluminescent organique selon une des revendications précédentes, dans lequel le matériau de transport d'électrons est choisi dans le groupe comprenant les matériaux avec une des formules structurales suivantes et les dérivés et combinaisons de ceux-ci : 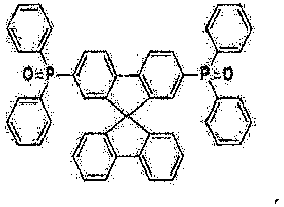 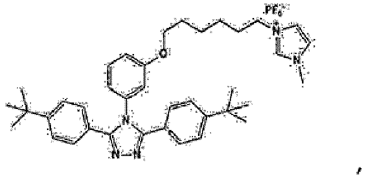 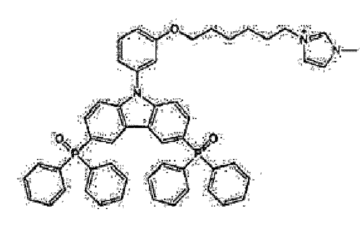 et

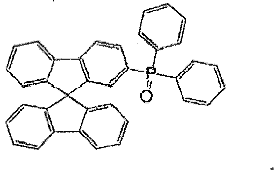

12. Dispositif électroluminescent organique selon une des revendications précédentes, dans lequel le matériau de transport de trous est choisi dans le groupe de matériaux comprenant une des formules structurales suivantes et les dérivés et combinaisons de celles-ci : 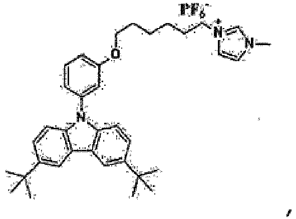 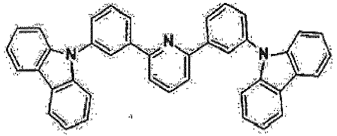 et

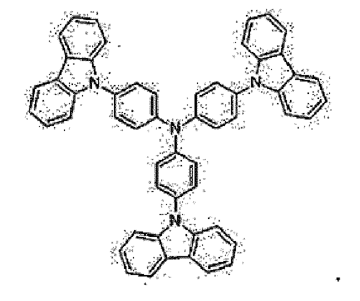

13. Dispositif électroluminescent organique selon une des revendications précédentes, dans lequel le matériau émetteur comprend un métal de transition, le métal de transition étant choisi dans le groupe comportant un métal de transition du groupe du platine du tableau périodique et un métal de transition du groupe du cuivre du tableau périodique.

14. Dispositif électroluminescent organique selon une des revendications précédentes comprenant une couche de blocage d'électrons, qui est disposée au-dessus de la première électrode (2).

15. Dispositif électroluminescent organique selon une des revendications précédentes comprenant une couche de blocage de trous, qui est disposée au-dessous de la deuxième électrode (4).

16. Dispositif électroluminescent organique selon une des revendications précédentes comprenant une couche organique fonctionnelle supplémentaire ou une pluralité de couches organiques fonctionnelles supplémentaires, la couche organique fonctionnelle (3) et au moins une couche organique fonctionnelle supplémentaire étant empilées.

17. Dispositif électroluminescent organique selon la revendication 16, dans lequel la couche organique fonctionnelle (3) et/ou au moins une couche organique fonctionnelle supplémentaire sont voisines dans un empilement d'au moins une couche fonctionnelle supplémentaire, les couches fonctionnelles supplémentaires étant choisies dans le groupe constitué par les matériaux de transport d'électrons, les matériaux d'injection d'électrons, les matériaux de transport de trous, les matériaux d'injection de trous et les combinaisons de ceux-ci.

18. Procédé de production d'un dispositif électroluminescent organique selon une des revendications 1 à 17 avec les étapes de traitement suivantes :
A) obtention d'un substrat (1),
B) obtention d'une première électrode (2) et d'une deuxième électrode (4),
C) obtention d'une couche organique fonctionnelle (3),
- la couche organique fonctionnelle (3) étant adaptée pour émettre un rayonnement électromagnétique,
- la couche organique fonctionnelle (3) comprenant un matériau matriciel et un matériau émetteur,
- le matériau émetteur étant neutre ou chargé ioniquement, chargé ioniquement signifiant que le nombre total d'électrons d'un atome ou d'une molécule n'est pas égal à leur nombre total de protons et l'atome ou la molécule a ainsi une charge électrique nette positive ou négative,
- le matériau émetteur étant choisi dans le groupe constitué par un complexe de métal de transition ionique, un complexe de métal de transition neutre, un émetteur polymère et les combinaisons de ceux-ci,
- le matériau matriciel comprenant au moins un matériau de transport porteur de charges ioniques,
- le matériau de transport porteur de charges ioniques étant choisi dans le groupe constitué par un matériau de transport d'électrons, un matériau de transport de trous, un matériau de transport ambipolaire et les combinaisons de ceux-ci, et
- l'au moins un matériau de transport porteur de charges ioniques étant chargé ioniquement,
- le matériau matriciel et le matériau émetteur étant mélangés, et
D) dépôt au moins de la couche organique fonctionnelle (3) par un procédé qui est choisi dans le groupe constitué par le dépôt à la tournette, le couchage à la lame, l'enduction par filière plate, la sérigraphie, l'impression flexographique, la rotogravure, l'impression par jet d'encre et les combinaisons de ceux-ci.
